Europäisches Patentamt

European Patent Office

Office européen des brevets

(11) Publication number: **0 481 362 A2**

# EUROPEAN PATENT APPLICATION

(21) Application number: **91117306.0**

(51) Int. Cl.5: **H01L 29/28**

(22) Date of filing: **10.10.91**

(30) Priority: **10.10.90 IL 95953**
**05.07.91 IL 98753**

(43) Date of publication of application:
**22.04.92 Bulletin 92/17**

(84) Designated Contracting States:
**AT BE CH DE DK ES FR GB GR IT LI NL SE**

(71) Applicant: **YEDA RESEARCH AND DEVELOPMENT CO. LTD.**
**P.O. Box 95**
**Rehovot 76100(IL)**

(72) Inventor: **Sagiv, Jacob**
**Meonot Wolfson 31/A, Weizmann Institute of Science**
**76 100 Rehovot(IL)**
Inventor: **Maoz, Rivka**
**Meonot Wolfson 31/A, Weizmann Institute of Science**
**76 100 Rehovot(IL)**

(74) Representative: **Modiano, Guido et al**
**MODIANO, JOSIF, PISANTY & STAUB**
**Baaderstrasse 3**
**W-8000 München 5(DE)**

(54) Composite organic-inorganic superlattices.

(57) A chemically controlled self-assembly process which allows precise sequential building of any desired number of discrete mono-molecular and/or mono-atomic layers, or monolayers, containing both organic and inorganic species, so that various combined or intercalated organic-inorganic layered structures, or superlattices, with precisely predetermined monolayer order, in the direction of the layer stacking, may be produced on various solid substrates. Each layer may be made of one or a combination of several distinct chemical species, either organic or inorganic or organic-inorganic, and different layers may be deposited in various periodic or non-periodic sequences. The layers may be crystalline or amorphous, with or without interlayer and/or layer-solid substrate epitaxial relationship. In addition, the built-up superlattice structure may be further modified by post-assembly intercalation and/or chemical modification processes.

**ARTIFICIAL SUPERLATTICE**

Compositional Modulation

```
C C C C C C C C C
B B B B B B B B B
A A A A A A A A A
C C C C C C C C C
B B B B B B B B B
A A A A A A A A A
```
SUBSTRATE

FIG. 1

## FIELD AND BACKGROUND OF THE INVENTION

The present invention relates to a method of synthesizing superlattices and, more particularly, to a method for making layered structures, each layer being a mono-molecular or mono-atomic film, with compositional modulation from layer to layer.

Recent advances in solid-state physics and related high vacuum technologies, such as Molecular Beam Epitaxy (MBE) techniques, have led to the development of certain types of artificial semiconductor and metal superlattices, raising interest in the potential applications of those superlattices in a range of novel microelectronic and optical devices (see, for example: T. Shinjo and T. Takada, "Metallic Superlattices", Elsevier, Amsterdam-Oxford-New York-Tokyo, 1987, and references cited therein).

Several techniques for depositing monolayers on a solid substrate are currently known. The techniques are limited to certain types of materials, requiring the use of expensive equipment, and are difficult to apply with precision since they are based on the deposition of an amount of chemical calculated to yield a coating layer which is statistically a monolayer.

The preparation of well-defined one-molecule-thick layers (monolayers) of certain organic compounds via spontaneous adsorption or chemisorption of the molecular layer components from a fluid phase onto a polar solid surface in contact with the fluid phase was pioneered by Zisman and coworkers [W.C. Bigelow, D.L. Pickett and W.A. Zisman, J. Colloid Sci. 1, 513 (1946)]. The basic monolayer self-assembly process involving the spontaneous formation of an ordered solid-supported monolayer at the solid-fluid interface without the assistance of mechanical deposition operations has been more recently extended to effect the controlled preparation of ordered multilayer films with well defined layer compositions and sequence [J. Sagiv, U.S. Patent No. 4,539,061 (1985); L. Netzer and J. Sagiv, J. Amer. Chem. Soc., 105, 674 (1983); L. Netzer, R. Iscovici, and J. Sagiv, Thin Solid Films, 99, 235 (1983); 100, 67 (1983)]. Such organic self-assembling multilayer films are prepared by the repetition of a sequence of two-steps, involving first the spontaneous self-assembly on the selected solid surface of an ordered monolayer, followed by chemical modification of the outer exposed layer surface so as to create surface binding sites to which a next well-defined self-assembling monolayer of the same or a different material may adhere. Repetition of this two-step sequence, for each deposited layer, enables deposition of any number of discrete self-assembling monolayers, one on top of the other, in a precisely controllable fashion.

The above described multilayer deposition methods are applicable to certain bifunctional molecules, having both a terminal binding function at one end, and a non-binding moiety at the other end of the molecule, or at some other position along the molecule. Such bifunctionality facilitates the oriented anchoring of the molecule, with the binding function attaching to a polar solid surface or to a chemically modified film-coated surface, and with the non-binding moiety pointing away from the surface. The non-binding moiety should be a binding site precursor, or possess a latent binding function, in the sense that its activation by an appropriate surface chemical operation can convert the non-binding moiety into an active binding group. It has been demonstrated that the use of such bifunctional layer-forming molecules ensures precise chemical control of the sequential deposition of discrete monolayers, since the deposition of each additional layer in a growing multilayer structure is possible only following the appropriate chemical activation of the binding site precursor groups of the previously deposited layer.

A conceptually similar step-by-step chemical process for the controllable successive deposition of layers of inorganic ions from aqueous solutions onto solid substrates has been reported [Y.F. Nicolau, Applications of Surface Science, 22/23, 1061 (1985)]. This process makes possible the layer-by-layer deposition of polycrystalline or epitaxial thin films of certain water-insoluble inorganic compounds. The process consists of an alternate immersion of the solid substrate in a solution containing a soluble salt of the cation of the compound to be deposited, followed by thorough rinsing in pure water and then by immersion in a solution containing a soluble salt of the anion. Films of chalcogenide semiconductor materials, such as ZnS and CdS, have been constructed by this method on various inorganic crystalline surfaces.

It would be desirable to have a generalized method of creating superlattices of any desirable structure and chemical composition and involving any desirable chemical or physical bonding methods between the monolayers of the superlattices, and which will yield precise monolayers without the disadvantages of the prior art.

## SUMMARY OF THE INVENTION

According to the present invention, there is provided controlled self-assembly process for the production of a composite organic-inorganic superlattice structure attached to a solid substrate, the structure comprising discrete monolayers of organic, inorganic and/or organic-inorganic species, the method comprising forming a first discrete monolayer on the solid substrate by spontaneous adsorption/chemisorption of the layer constituents from an adjacent fluid, under conditions preventing self-adherence of the layer constituents on top of said first monolayer, and triggering sequential deposition of additional discrete monolayers in a discontinuous, stepwise manner, each layer being formed by spontaneous adsorption/chemisorption of the layer constituents from an adjacent fluid, such that in each step self-adherence of the layer constituents on top of the respective layer is prevented.

According to a further feature of the invention there is provided a process wherein the triggering of the deposition of a monolayer is effected by modification of the chemical nature of a latent binding function of the exposed outer surface of the last deposited layer, thus converting it into an active binding group which enables the adsorption/chemisorption on top of it of an additional discrete monolayer of a desired species, which may be the same or a different species.

According to a further feature of the invention there is provided a process wherein the triggering is effected by alternating the deposition of layers of different species such that the species have adequate affinity to each other so that the exposed outer surface of a monolayer of one of the species enables the adsorption/chemisorption on top of it of an additional discrete monolayer of the other species. Adequate affinity includes lack of self-adherence affinity of the species.

Each monolayer may be wholly organic or inorganic or organic-inorganic. The entire superlattice must contain both organic and inorganic species to fall within the scope of the invention.

According to a preferred embodiment of the present invention, the superlattice contains organic monolayers formed from amphiphilic molecules or chromophores and inorganic monolayers formed from a species containing a metal ion which may be mono- or polyvalent.

According to further embodiments of the present invention, the solid substrate of the superlattice is glass, quartz, a metal, a semiconductor, a polymeric or any other suitable amorphous or crystalline material.

According to further embodiments of the present invention, a superlattice formed as above is modified through the intercalation of distinct chemical species between the layers, with optional chemical modification of the intercalated species of the initial superlattice or of both.

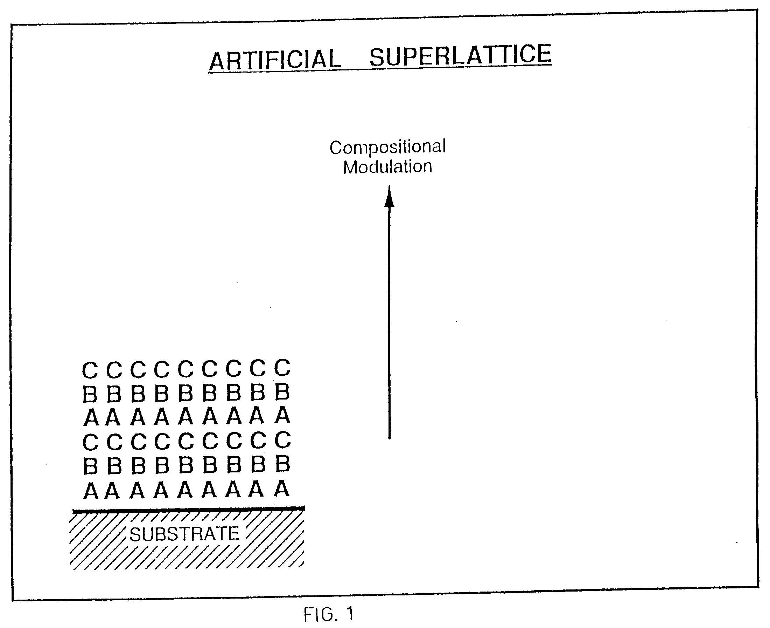

The present invention provides a chemically controlled self-assembly process which allows precise sequential building of any desired number of discrete one-molecule thick and/or one-atom thick layers, each containing both organic and/or inorganic species, so that various combined or intercalated organic-inorganic layered structures, or superlattices, with precisely predetermined molecular/atomic order, at least in the direction of the layer stacking, may be produced on various solid substrates (Fig. 1). Each layer within these novel types of composite superlattices of the present invention may be made of one or a combination of several distinct chemical species, either organic or inorganic, and different layers may be deposited in various periodic or non-periodic sequences. The layers may be crystalline or amorphous, with or without interlayer epitaxial relationship, and/or epitaxial relationship to the superlattice solid substrate. In addition, certain new species may be formed following synthesis through processes of post-assembly intercalation, with optional further chemical modification.

The present invention is of film building processes for the preparation of composite organic-inorganic superlattices. Within the scope of the present invention are methods of producing composite organic-inorganic superlattices featuring the following general properties:

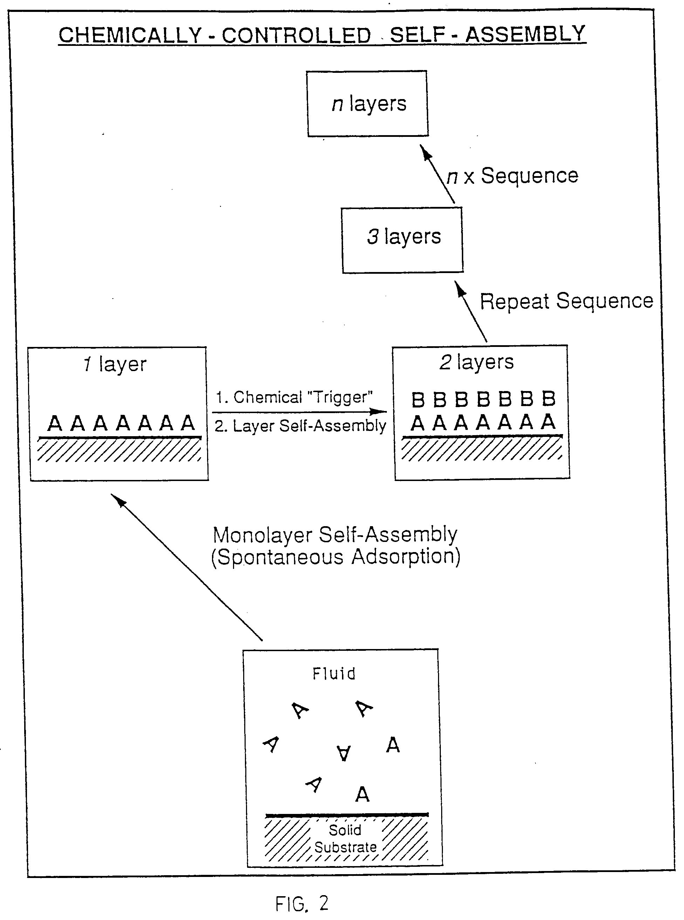

1. Each monolayer of the superlattice structure is obtained by self-assembly, i.e., as the result of spontaneous adsorption/chemisorption and self-organization of the molecular/atomic layer constituents at the interface of a selected solid substrate on which the superlattice is constructed and an adjacent fluid phase, such as solution, melt or vapor, containing the layer constituents (Fig. 2).

2. The molecular/atomic constituents of each deposited layer and the physico-chemical conditions under which the adsorption/chemisorption of the layer constituents is conducted must be selected in a manner which ensures the formation of a discrete monolayer of these constituents, with no deposition of material taking place beyond the amount required to cover the given solid substrate with a compact, well-defined single monolayer of the appropriate material. Thus, there should be no physical or chemical affinity on the part of the layer constituents for the layer-covered surface, which might lead to self-adherence and uncontrolled deposition of additional material beyond that necessary and sufficient to cover the previous surface with a monolayer.

3. Deposition of additional discrete monolayers on top of a previously deposited layer must proceed in a discontinuous, stepwise manner. The formation of each new layer should require deliberate initiation by means of an externally switchable chemical triggering mechanism. As chemical "trigger" one could consider any appropriate change in the composition, or in any number of other physico-chemical parameters characteristic of the environment of the solid substrate which is effective in modifying or affecting the chemical nature of the exposed outer surface of the solid substrate or of the last deposited layer in a way which will facilitate the adsorption/chemisorption of an additional discrete monolayer. This procedure ensures that precise external control is maintained on the otherwise spontaneous self-assembly of each individual monolayer.

The expressions "solid substrate" and "surface" as used herein are intended to encompass both the original solid substrate and the monolayers-covered solid substrate.

The chemical "trigger" operation may consist of a surface chemical reaction resulting in the insitu modification of a latent binding function, or binding site precursor, into an active one, as defined by Sagiv in U.S. Patent No. 4,539,061, which is herein incorporated by reference in its entirety. According to the present invention there are many other methods for "triggering" the monolayer self-assembly process. Under certain conditions it may even occur that the alternate deposition of one layer will automatically trigger the deposition of another layer. For example, while each of the constituents in the adjacent fluid should not adhere to its own layer, each of them may have sufficient affinity for the other, so that the deposition of a layer of one of the materials automatically creates an exposed outer surface on which adsorption of a layer of the other material may occur. In this case, layer self-assembly and triggering occurs in one single step (Fig. 2).

The chemical "trigger" is thus to be regarded as any operation or sequence of operations, involving chemical, photochemical or electrochemical processes or reactions. Such processes or reactions may be mediated by various chemical reagents, electrical current, electromagnetic radiation of any wavelength, electric or magnetic fields, electron or ion beams, electric discharge, or plasma of any type. Other triggering mechanisms included are ion/molecular exchange processes, adsorption/chemisorption of any appropriate organic, inorganic and/or organic/inorganic species from a solution, melt or vapor phase, change in the nature of the solvent, such as from organic to aqueous or vice versa, change in the composition of the solvent or composition of a vapor phase environment, change of temperature, pressure, vapor pressure, or any other chemical or physical operation or set of operations which are effective in modifying the exposed outer surface of a solid substrate, or that of the last deposited layer of a solid-supported superlattice structure, so as to facilitate its utilization as "active" substrate, i.e., as substrate on which the self-assembly of a new layer of one or of a mixture of selected materials is possible.

Organic-inorganic superlattice structures of the types described in this invention have potential commercial applications as polar non-centrosymmetric thin films exhibiting non-linear optical response (second harmonic generation, SHG), ferroelectricity and piezo and pyroelectricity, thin films exhibiting planned photoelectric effects, specific electrochemical and photoelectrochemical response, photochromic and electrochromic effects, electrical rectification (diode effects), magnetic thin films with ferromagnetic, antiferromagnetic or paramagnetic properties, thin films exhibiting selective permeability towards certain molecular and ionic species (selective membranes), ultrathin coating films exhibiting controllable adsorptivity or controllable lateral diffusion or transport characteristics towards certain selected molecular and/or ionic species, superconducting films, films exhibiting other useful chemical, electrochemical, photochemical, optical, electric, magnetic, permeation, diffusion or lateral transport property.

Applications of superlattice films according to the present invention are of value in a number of novel electronic, optical and optoelectronic microdevices, devices based on superconducting effects, sensors of various types, photocells and photoelectrochemical cells, including use in solar energy conversion, display technology, special ultrathin coatings for optical fibers, semiconductors, metals, ultrathin separatory membranes and ultrathin coatings for the production of molecularly engineered adsorbents for various chromatographic, electrophoresis, or related separation processes, ultrathin coatings for various metal or semiconductor materials, for use as molecularly engineered electrodes in various applications based on electrochemical and/or photoelectrochemical processes, ultrathin film coatings with desirable special properties for any polymeric or mineral material, including porous material.

## BRIEF DESCRIPTION OF THE DRAWINGS

The invention is herein described, by way of example only, with reference to the accompanying drawings, wherein:

Fig. 1 is a schematic illustration of an artificial superlattice structure, with A, B, C, .... representing different molecular/atomic species.

Fig. 2 depicts schematically a general scheme of the construction of artificial superlattices via chemically controlled self-assembly.

Fig. 3 is a schematic illustration of the chemically controlled self-assembly of superlattice structures made of monolayers of organic long chain amphiphiles and inorganic metal ions, showing different possible modes of inter and intralayer bonding.

Fig. 4 depicts FTIR-ATR spectra and difference spectra recorded in the Attenuated-Total-Reflection mode at an angle of incidence of 45°, showing the contribution of individual layers in an 8-layer superlattice film structure with ionic bonding to the solid substrate (ZnSe ATR crystal plate) and interlayer bonding of the ionic (phosphate-$Ca^{2+}$-carboxylate, first 4 layers), and covalent (silyl-carboxylate, next 4 layers) types.

Fig. 5 is a schematic representation of the composition of some superlattices of organic long chain amphiphiles with $Al^{3+}$ and $Ca^{2+}$ ions, involving different modes of inter and intralayer bonding.

Fig. 6 is a schematic representation of the stepwise assembly of a noncentrosymmetric polar superlattice structure with alternate layers of anisic acid chromophores and silver ions (AA-$Ag^+$).

Fig. 7 is a schematic representation of the stepwise assembly of a noncentrosymmetric polar superlattice structure with alternate layers of benzyl orange chromophores and silver ions (BO-$Ag^+$).

Fig. 8 is a schematic representation of the deposition of a layer of $Ag^+$ ions, from an aqueous solution of the $Ag^+$-p-toluenesulfonate (PTS) salt, on the outer surface of an AA (anisic acid) monolayer, and the surface ion-exchange process involved in the replacement of one monolayer of PTS ions by one monolayer of anisate ions, upon immersion in an organic solution of the neutral AA molecules.

Fig. 9 shows UV spectra (measured in direct transmission at normal incidence) of one monolayer of AA-$Ag^+$ [silver anisate(4-methoxybenzoate)] and one monolayer of DDBA-$Ag^+$ (silver 4-dodecyloxybenzoate) adsorbed on each side of a quartz slide precoated with an anchoring $C_{18}$-silane-carboxylate monolayer (as in Fig. 6).

Fig. 10 shows FTIR spectra and difference spectra (measured in direct transmission at normal incidence) of same DDBA-$Ag^+$ specimen as in Fig. 9, showing the individual contributions of the anchoring silane monolayer (upper curve) and the DDBA-$Ag^+$ monolayer (middle curve). The spectrum of an incomplete DDBA (4-dodecycloxybenzoic acid) monolayer adsorbed on each side of a bare quartz slide is also shown for comparison (lower curve).

Fig. 11 shows a UV spectrum (measured in direct transmission at normal incidence) of same DDBA incomplete monolayer specimen as in Fig. 10 lower curve.

Fig. 12 shows dichroic FTIR-ATR difference spectra (taken at an angle of incidence of 45°) of a monolayer of DDBA-$Ag^+$ absorbed on a silicon ATR crystal plate pre-coated with an anchoring $C_{18}$-silane-carboxylate monolayer (as in Fig. 6).

Fig. 13 shows UV spectra (measured in direct transmission at normal incidence) of 1, 2, 3, and 4-monolayers-thick film structures of AA-$Ag^+$ adsorbed on each side of a quartz slide precoated with an anchoring $C_{18}$-silane-carboxylate monolayer (as in Fig. 6).

Fig. 14 shows UV spectra (measured in direct transmission at normal incidence) of 1, 2, 3 and 4-monolayers-thick film structures of BO-$Ag^+$ adsorbed from an aqueous solution of BO on each side of a quartz slide pre-coated with an anchoring $C_{18}$-silane-carboxylate monolayer (as in Fig. 7).

Fig. 15 is a schematic illustration of the chemically controlled self-assembly of composite superlattice structures with intercalated layers of organic long chain amphiphiles and CdS.

Fig. 16 shows FTIR spectra and difference spectra (measured in direct transmission at normal incidence) of a composite organic amphiphile-CdS trilayer structure assembled on each side of a quartz slide, following the synthetic route indicated in Fig. 15.

Fig. 17 shows UV spectra (measured in direct transmission at normal incidence) taken at three distinct stages (as indicated by the respective inserts) during the assembly of same composite trilayer structure as in Fig. 16.

Fig. 18 is a schematic representation of the post-assembly intercalation of positive metal ions into a superlattice multilayer structure of a long chain amphiphile with interlayer coupling of the hydrogen- bond type (between -COOH and -SiOH moieties).

Fig. 19 shows FTIR spectra and difference spectra of a bilayer structure on Si, consisting of a first $C_{18}$ silane-carboxylic acid monolayer and a second $C_{18}$-silane monolayer hydrogen-bonded to the -COOH groups of the first layer (as in Fig. 18), before (a) and after (b,c,d) post-assembly intercalation of $Na^+$, $Cu^{2+}$ and $Fe^{3+}$ ions, respectively.

## DESCRIPTION OF PREFERRED EMBODIMENTS

The present invention may be better appreciated through the following detailed description of several types of embodiments and associated examples, which are included for illustrative purposes.

Superlattice Structures of Organic Long-Chain Bifunctional Amphiphiles with Intra and Interlayer Intercalated Inorganic Ions

The bifunctional organic amphiphiles described by Sagiv in U.S. Patent No. 4,539,061, are suitable for the construction of ion-containing superlattice structures according to the present invention. Inorganic ions, cations or anions, may be included as distinct constituents in such structures. Ions capable of multiple coordination or with formal valency higher than one are preferred because of their ability to bind multidirectionally and the remarkably improved structural flexibility, tenacity and physico-chemical stability which such ions thereby confer to the respective overall structures.

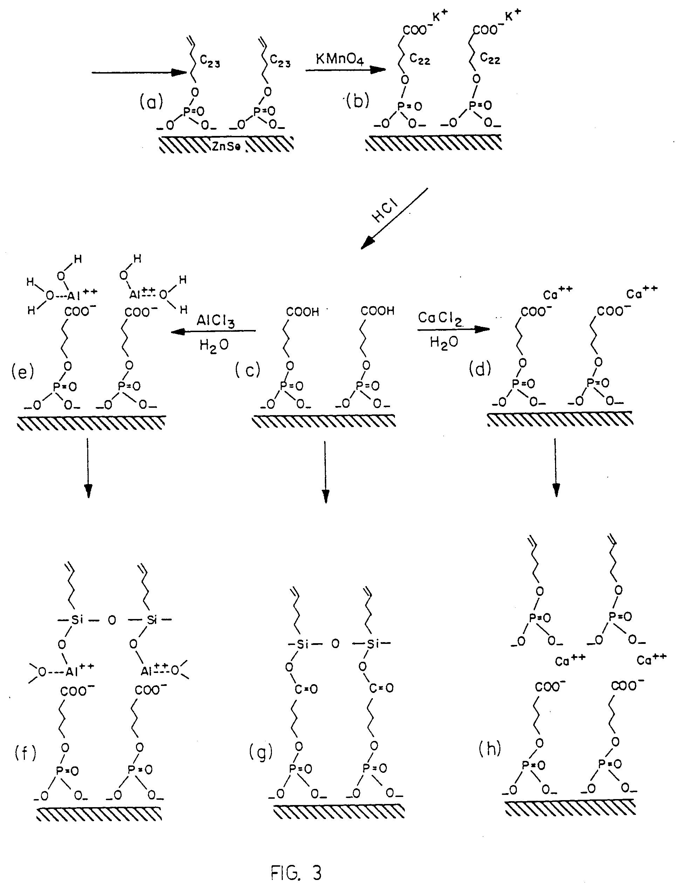

Fig. 3 provides, for illustrative purposes only, schematic examples of a number of specific synthetic routes enabling the stepwise construction of ion-containing organic-inorganic superlattice structures with interlayer coupling based on practically any type of known interlayer chemical bond, such as ionic, covalent, coordinative, or combined binding modes involving the simultaneous participation of any combination of covalent, ionic and coordination bonds. Interlayer hydrogen-bonded structures are also possible, as described hereinafter.

The bifunctional amphiphiles in Fig. 3 are $C_{23}$ and $C_{19}$ normal aliphatic chains having 23 and 19 carbon atoms, respectively, with a phosphate ester and respective chlorosilane binding function (polar head group) which is convertible into siloxane upon hydrolysis and condensation with a similar neighbor group, and a terminal ethylenic double bond, which serves as a latent binding function, with no intrinsic binding capability in its initial, inactivated form. Well defined, oriented monolayers of such bifunctional amphiphiles may be obtained on various polar solid substrates by self-assembly via spontaneous adsorption/chemisorption from organic solutions, involving the anchoring of the polar head groups to the polar solid, and the exposure to the outer environment of the non-binding ethylenic double bond functions.

In-situ surface chemical modification, or activation, of the exposed ethylene double bonds, for example upon reaction with crown-ether-solubilized $KMnO_4$ in benzene [R. Maoz and J. Sagiv, Thin Solid Film, 132, 135 (1985)], leads to terminal carboxylic-carboxylate acid functions (-COOH; -COO$^-$) which serve as surface-immobilized active binding sites, to which a next monolayer may be anchored via an analogous self-assembly adsorption process. The interlayer anchoring is achieved either by direct covalent coupling [(Fig. 3(g)] or via ionic and coordinative coupling, involving any of a large variety of inorganic cationic species [Figs. 3-(h) and (f)]. Various ion-exchange and complexation processes may also be carried out on the surface utilizing these functions.

The large variety of possible composition-structure variations in the construction of multilayer systems based on organic and inorganic components of the types indicated in Fig. 3 is evident from Figs. 3(f), (g) and (h). Repetition of the adsorption and surface chemical modification steps [Figs. 3(a), (b)], with either the phosphate, the silane, or other amphiphiles (also including cationic species such as ammonium derivatives), and introduction of various inorganic cations or anions, from either aqueous or organic environments [Figs. 3(d), (c), (e)] may be utilized to achieve practically unlimited diversity in chemical composition, sequence, and total number of superimposed layers.

## Superlattice Structures of Organic Chromophoric Molecules with Intra and Interlayer Intercalated Inorganic Ions

Hydrophobicity, which is a basic condition in the formation of insoluble Langmuir monolayers on water, is not required for the self-assembly of monolayers from a bulk fluid phase. The presence of highly hydrophobic moieties, such as long hydrocarbon or fluorocarbon chains, or saturated polycyclic units, such as steroidal skeletons, is thus not a necessary requirement in monolayer self-assembly. Consequently, various compounds, such as organic chromophores and other molecules with delocalized $\pi$ electrons, which may be of interest in connection with their special optical or electronic properties, can be successfully self-assembled into ordered mono- and multilayer structures. The preparation of active layers of chromophores, free of the superfluous, or even detrimental, presence of large and inert hydrophobic moieties, becomes possible via chemically controlled self-assembly.

Chromophoric compounds suitable for use as layer components in the construction of superlattice structures according to the present invention must be equipped with appropriate binding functions and latent binding functions or binding site precursors. Their molecular geometry should be sterically compatible with the desired orientation and packing in an ordered surface layer, and the surface bound molecules should withstand the necessary chemical modification operations providing the chemical "trigger" for the deposition of additional layers. The binding and latent binding functions in such chromophoric compounds may be selected as integral parts of the active chromophore, or even as the entire chromophore itself, in which case the sequential deposition of such layers on top of each other will result in new chromophoric entities, i.e., the initial ones after their modification as effected by the respective selected modes of intra/interlayer binding. Charge redistribution due to electrostatic forces, orbitals overlap, dipole-dipole, charge-dipole, and other intermolecular interactions may determine the final properties of such chromophoric superlattices.

Superlattice Structures Combining Organic Molecules with Inorganic Semiconductor and Metal Components

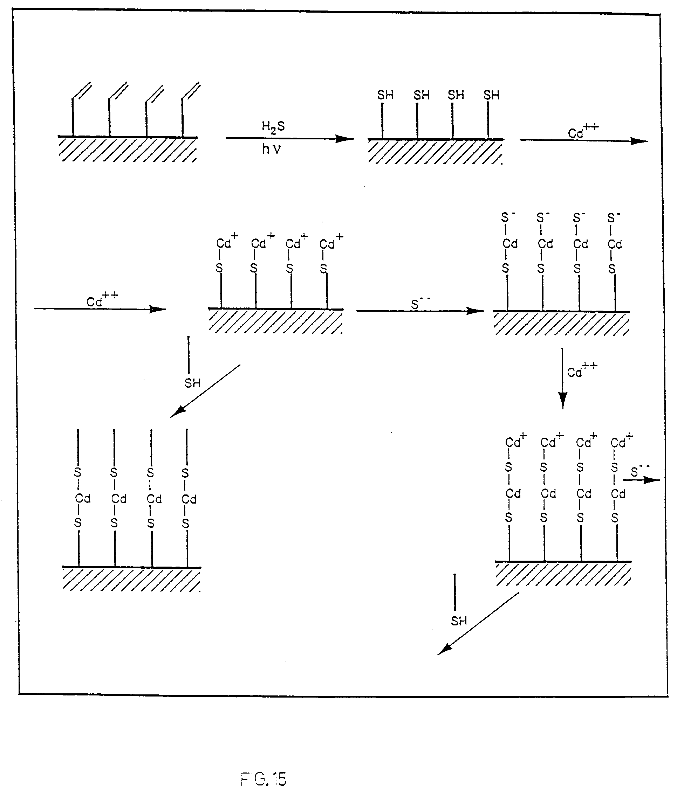

Fig. 15 depicts schematically the chemically controlled self-assembly of a family of composite superlattice structures with intercalated layers of a long chain hydrocarbon amphiphile and an inorganic chalcogenide semiconductor material (CdS). The deposition process in Fig. 15 consists of a sequence of chemical steps, each of which results in the addition of a discrete layer of just one chemical species, while providing the necessary trigger for the deposition of a next layer having affinity for the layer already deposited. Thus, a sulfide layer is generated on the outer surface of the organic monolayer through photochemical addition of $H_2S$ to the terminal double bond of the hydrocarbon amphiphile, which creates a surface with high chemical affinity for $Cd^{2+}$ ions. A layer of cadmium ions may then be introduced by adsorption from a solution of a soluble cadmium salt, followed by any desired number of additional sulfide and cadmium layers, deposited sequentially from solutions of soluble salts of the respective ions [see Y.F. Nicolau, Applications of Surface Science, 22/33, 1061 (1985)]. The inorganic sulfide may be replaced, at any stage of this layer-by-layer build-up process by an organic thiol (mercaptan), thus yielding an outer layer of the respective cadmium thiolate (mercaptide), to which $H_2S$ may again be added through the above photochemical reaction. By selecting an appropriate sequence of such steps one may utilize processes such as those depicted in Fig. 15 to create a large variety of composite superlattices in which CdS layers with the desired molecular thickness are intercalated with organic hydrocarbon layers of variable thickness.

"Ultrasuperlattices" Combining Components of Each of the Aforementioned Types

From the discussion above it is apparent that extremely complex superlattice configurations, with combined and intercalated components of any of the above categories, can, in principle, be obtained utilizing processes of chemically controlled self-assembly described herein. Such processes, selected to yield the desired structural and compositional configuration to be created, should enable the controlled deposition of different types of layers and mixed-type layers, in any desired sequence and number. The possible assembly of such "ultrasuperlattices" is expected to lead to novel molecularly-engineered materials exhibiting a wide range of desirable new properties. It also offers the ability to design artificial supramolecular assemblies capable of performing complex functions, by virtue of their preselected microarchitecture.

Post-Assembly Intercalation and/or Chemical Modification

Composite organic-inorganic superlattices prepared by the sequential deposition of discrete monolayers, according to the chemically-controlled self-assembly processes disclosed above, may be utilized as starting materials in the assembly of other, more complex, superlattices, using processes of post-assembly intercalation and/or chemical modification. In general, the intercalation is achieved by replacing mobile atomic or molecular species, charged or neutral, located within the stable multilayer backbone of a superlattice produced according to any of the processes disclosed above, with other mobile species diffusing from an adjacent fluid or solid phase brought in contact with the initial superlattice. Such intercalation processes may be repeated any number of times, in any practically useful manner, so as to create a large variety of new multilayer intercalated structures.

This intercalation approach offers the additional possibility of simultaneous modification of some or all layers of a superlattice initially produced in the self-assembly process described above. The initial superlattice plays the role of a fixed 3-dimensional layered template which controls the intercalation of selected mobile species into an organized 3-dimensional structure with predefined architecture. Thus, various chemical species will be intercalated into various interlayer spaces of the initial superlattice, according to the chemical characteristics of the respective layers and respective intercalable species.

Furthermore, either superlattices assembled by the step-by-step processes disclosed above, or superlattices constructed by post-assembly intercalation, may be further modified by subsequent chemical transformations conducted on the entire superlattice and leading to the in situ generation of new chemical species in the superlattice layers or between them. Such transformations include chemical, photochemical, and electrochemical processes or reactions involving one or more superlattice species, or a superlattice species and one or more outer species diffusing into the superlattice, for example, from an outer gas, liquid or solid medium, including the solid substrate of the superlattice, or a superlattice species and other species or a reagent located in an outer medium contacting the superlattice, including the superlattice solid substrate.

A large variety of such chemical conversion processes are conceivable, including chemical intralayer reactions or combinations, including also complexations and hydrogen bond formation, of two or more simultaneously or sequentially intercalated species, reactions involving Xelectron transfer between species located in different layers of the superlattice, intralayer electron transfer, superlattice - outer medium electron transfer, superlattice - solid substrate electron transfer, decomposition reactions of superlattice species into new species, with or without diffusion of all or part of the decomposition products out of the superlattice, "chain" transformations involving several consecutive or consequential processes of the kinds mentioned above.

Finally, complex "superlattice-within-superlattice" structures may be assembled by sequential intercalation, with or without further chemical modification, leading to the layer-by-layer formation of a new set of multilayers within all or a selectable portion of the interlayer spaces of the initial superlattice.

Post-assembly intercalated chemically-modified superlattices produced by the present process have applications of all the types mentioned above in the context of superlattices produced by chemically controlled self-assembly. In addition, the mobility of intercalated exchangeable species confers upon the intercalated structures additional potential applications as:

(a) active elements in new types of molecularly engineered chemical or electrochemical separation processes, such as Molecular-Scale Chromatography or Molecular-Scale Electrophoresis, based on adjustable differences in the rates of diffusion and/or selective diffusion of molecular/atomic/ionic species of interest in adequately engineered superlattice interlayer planes;

(b) miniaturized integrated sensor devices operating on the basis of chemical or electrochemical separation processes of the kind mentioned above, making possible the scaling down of analytical operations to micro quantities of material much smaller than can be achieved with presently known techniques of micro analysis;

(c) precisely engineered thin films with special magnetic, electrical, optical and electro-optical properties;

(d) novel thin film electrical conductors, with either or both electronic and ionic conductivity;

(e) novel types of artificial layered superconductors and high Tc superconductors;

(f) novel thin films for high density information storage, such as magnetic storage, optical storage, photographic storage and chemical storage;

and

(g) novel composite films for photochemical and photoelectrochemical solar energy conversion.

## EXAMPLES

The processes described above may be further understood with reference to a number of examples which are described below.

Example 1: Superlattice Structures of Organic Long-Chain Bifunctional Amphiphiles with Intra and Interlayer Intercalated Inorganic Ions

A composite superlattice with 8 organic layers on ZnSe substrate, with ionic and covalent interlayer bonds, was assembled while monitoring, as described below, various experimental parameters related to the structure reactivity and structural stability of the layers on the ZnSe surface.

A ZnSe ATR crystal plate (Harrick, single pass, parallelepiped, 50 x 10 x 3 mm, 45° aperture angle) was activated (cleaned) for adsorption by 20 minutes extraction with boiling toluene in a Soxhlet extractor, followed by 10 minute exposure to argon plasma in a RF discharge apparatus (Harrick PDC-3XG). A first phosphate layer was adsorbed on the activated ZnSe surface by immersing the ZnSe plate for 15 minutes in a $4.0 \times 10^{-4}$ M solution of the $C_{23}$ phosphate amphiphile (22-tricosenyl dihydrogen phosphate), in bicyclohexyl at ambient temperature, after which the plate was withdrawn and rinsed for 15 minutes in pure toluene at ambient temperature.

The synthesis of 22-tricosenyl dihydrogen phosphate can proceed as follows. The $C_{23}$-phosphate-terminal double bond amphiphile was synthesized starting with the commercially available 10-undecenoyl chloride and 1-morpholinocyclododecene (Fluka), and proceeding along a synthetic route leading to extension of the hydrocarbon chain 11 to 23 carbon atoms and final introduction of the phosphate ester function. The condensation of the 10-undecenoyl chloride with 1-morpholinocyclododecene in the presence of triethylamine in chloroform, followed by acid hydrolysis, and the opening with KOH of the $C_{12}$ ring of the resulting undecenoyl cyclododecanone, were performed by a procedure similar to that described by Hunig and Lucke [S. Hunig and E. Lucke, Chem. Ber. 92, 652 (1959)]. The $C_{23}$ keto-acid was converted to the respective tosyl hydrazone by stirring a mixture of the keto-acid and tosyl hydrazine in glacial acetic acid for 72 hours at the ambient temperature, after which the mixture was poured in water and the precipitated solid filtered, dried, and recrystallized from methanol. The tosyl hydrazone product was reduced with $NaCNBH_3$ in

acidic dimethylformamide (DMF) and sulfolane according to Hutchins et al. [R.O. Hutchins, C.A. Milewski and B.E. Maryanoff, J. Amer. Chem. Soc., 95, 3662 (1973)]. The resulting $C_{23}$ carboxylic acid was esterified with methanol by the dicyclohexylcarbodiimide (DCC) method, in the presence of 4-dimethylaminopyridine (4-DMAP) in Benzene [B. Neises and W. Steglich, Agnew. Chemie Int. Ed. Engl. 17, 522 (1978)], and the methyl ester reduced to the $C_{23}$ alcohol with $LiAlH_4$ in diethyl ether. Esterification of the $C_{23}$ alcohol with phosphorus oxychloride, followed by hydrolysis in $H_2O$ of the resulting $C_{23}$ phosphorodichloridate, by a method similar to that of Cremlyn et al. [R.G.W. Cremlyn, B.B. Dewhurst, and D.H. Wakeford, Synthesis, 648 (1971); R.J.W. Cremlyn and N.A. Olsson, J. Chem. Soc. (C), 2305 (1969)], and recrystallization from dioxane, afforded the final 22-tricosenyl dihydrogen phosphate product.

The monolayer coated surface obtained above is hydrophobic, autophobic and oleophobic, i.e., it is not wetted by water, by the adsorption solution or by a series of liquids usually employed in wettability studies, such as pure bicyclohexyl (BCH), n-hexadecane (HD), and toluene (employed in the present preparation as a rinsing solvent), producing typical contact angle values with no difference or only a very small difference between advancing and receding angles (no contact angle hysteresis): 51°-49° for BCH; 43°-42° for HD; 100°-98° for $H_2O$. Repetition of the adsorption/rinse cycle did not lead to any further change in the amount of the adsorbed material, as evidenced by the IR and contact angle data, indicating the formation of a densely packed and well defined phosphate monolayer.

The chemical modification (oxidation) of the outer exposed ethylenic double bond functions of the $C_{23}$ phosphate monolayer into terminal $K^+$-carboxylate functions (the chemical "trigger" operation) was carried out by immersing the monolayer-coated ZnSe plate in a $1.0 \times 10^{-3}$ M benzene solution of the $KMnO_4$-crown ether complex, consisting of equimolar quantities of $KMnO_4$ and dicyclohexano-18-crown 6 (Sigma, 98%) dissolved in benzene at ambient temperature, for a total period of time of about 44 hours. During the first hour of immersion in the $KMnO_4$ reagent, the plate was withdrawn every 5-10 minutes, rinsed with cold toluene and checked for the presence of residual double bond functions (by IR and wettability measurements). It was found that about 80%-90% of the double bonds were oxidized within one hour, while much larger reaction times (up to a total of about 44 hours) were required to bring to completion the oxidation of the remaining unreacted functions. The reaction procedure finally adopted was to perform 4 reaction cycles of about 10-12 hours each, with thorough rinsing of the plate with cold toluene, and replacement of the $KMnO_4$-crown ether solution with a fresh one after the completion of each reaction cycle. After a total reaction time of about 44 hours, following this procedure, the outer monolayer surface consisting of carboxylate (-$COO^-K^+$) polar functions is wetted by each of the above-mentioned test liquids, i.e., it becomes both oleophilic and hydrophilic. The carboxylate surface functions were converted into free carboxylic acids (-COOH) by immersion for 10 minutes in a solution of 5% HCl in double distilled water, followed by rinsing with cold toluene.

The conversion of the free acid functions into the respective $Ca^{2+}$ salt (-$COO^-Ca^{2+}$) was accomplished by immersion for 30 minutes in a $2 \times 10^{-4}$ M solution of $CaCl_2$ in double distilled water and final rinse in cold toluene.

A second phosphate layer was adsorbed through the formation of ionic bonds [as in Fig. 3-(h)] on the $Ca^{2+}$ carboxylate outer surface of the modified first layer in a manner identical to the adsorption of the first phosphate layer on the bare ZnSe surface, and the surface chemical modification and adsorption of two additional phosphate layers in the structure were carried out by the same procedures as described above for the first layer. Identical contact angles were measured on each of the four phosphate layers.

Four additional silane layers were sequentially adsorbed on top of the four phosphate layers through the formation of covalent bonds [as in Fig. 3(g)] from a $2.0 \times 10^{-3}$ M solution of the $C_{19}$ silane amphiphile (18-nonadecenyltrichlorosilane-NTS) in BCH at ambient temperature (10 minute adsorption time) followed by thorough rinsing with cold toluene. Contact angles similar to those of the phosphates were measured on each of the silane layers.

The surface chemical modification of each of the silane layers was performed in a manner identical to that of the phosphate layers, except for the immersion in the $CaCl_2$ solution.

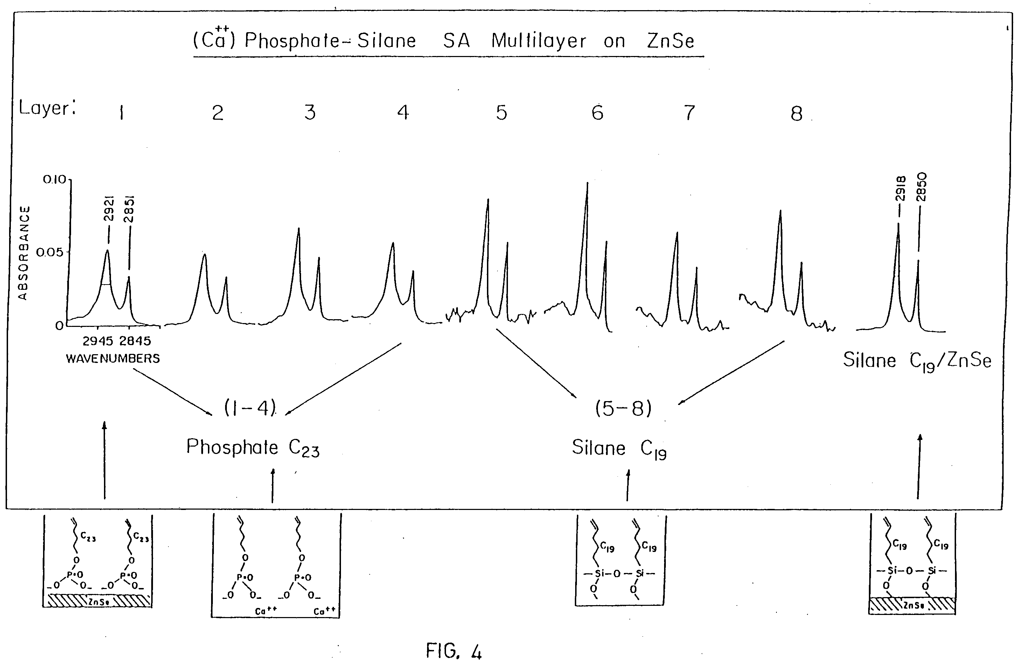

Fig. 4 shows a series of ATR-FTIR (Attenuated Total Reflection - Fourier Transform Infrared) spectra and difference spectra recorded during the construction of the 8 organic layer superlattice structure of this example. Curves 2-8 are different spectra, each n-th layer contribution being obtained as the mathematical subtraction of the spectrum of n-1 layers from that of the corresponding n-layers film (the composition of each layer in the structure is schematically indicated in the corresponding inserts). For comparison, the spectrum of a monolayer of the $C_{19}$-silane adsorbed directly on the AnSe surface is also shown (first curve from right). The difference spectra provide evidence for the discrete deposition of individual layers in this 8 organic layer superlattice structure. The structural perfection of each of the 8 organic monolayers is demonstrated by the corresponding integrated peak intensities, which are constant and proportional to the chain length of the respective layer forming amphiphile, as well as by the typical and constant angles recorded for three representative liquids on each of the 8 layers. Observed differences in peak width and position, between the phosphate and the silane layers, are indicative of significant lack of interlayer correlation as regarding the in-plane lateral distribution and packing of the respective paraffinic chains. Thus, the lateral molecular distribution within each layer of a multilayer structure of this type may be largely independent of that of the layer located underneath it. Intralayer lateral interactions should, therefore, prevail in such situations. This suggests interesting possibilities as regarding the development of continuous, gap-bridging monolayers, applicable, among others, to the preparation of ultrathin molecularly engineered membranes.

It should be emphasized that the quantitative conversion of the outer double bond functions into carboxylates, for which very long reaction times in the $KMnO_4$-crown ether reagent were required, is not a prerequisite for the adsorption of a complete phosphate or silane monolayer on top of the chemically modified one. Due to intralayer bridging effects, mediated by the spontaneous formation of lateral intermolecular bonds (of the ionic, coordinative, covalent, or mixed types), highly ordered compact monolayers may be obtained via self-assembly even on surfaces exposing a smaller number of active binding sites, compared to the number of molecules contained in a defect-free compact monolayer. Thus reaction times in the organic $KMnO_4$ solution of the order of one hour or less may be sufficient for regular deposition of monolayers of this kind.

It should also be understood that various other reaction paths may be successfully employed for the activation of the outer double bonds. For example, quantitative oxidation of ethylenic double bonds by aqueous $KMnO_4$ is achieved in much shorter time (about 30 minutes or less), leading, however, to a mixture of surface polar functions, such as acids, aldehydes, alcohols, rather than to a single, well defined species. Very fast oxidation with $O_2$ and $FeCl_3$ as catalyst is described hereinafter.

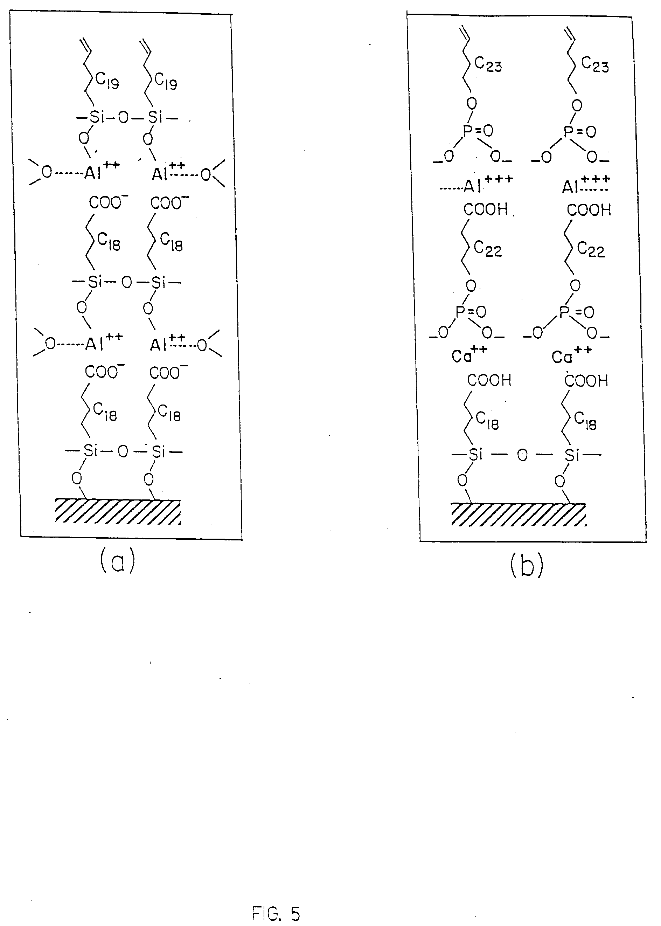

Other superlattice structures of long chain amphiphiles with inorganic ionic components have been successfully constructed on silicon, glass, quartz and mica substrates, and similarly analyzed. Some schematic structural compositions of superlattices of organic long chain amphiphiles with $Al^{3+}$ and $Ca^{2+}$ ions, involving different modes of inter- and intralayer bonding are depicted in Fig. 5 where the hydrocarbon chain (with 18, 19, 22, and 23 carbon atoms) are symbolically represented by segments containing only several $CH_2$ units per chain. They include (Fig. 5a) the silane-$Al^{3+}$-carboxylate covalent-ionic-coordinative mode of binding [as in Fig. 3(f)], the phosphate $Al^{3+}$-carboxylic acid ionic-coordinative mode of binding (Fig. 5b), with the $Al^{3+}$ ion introduced from either aqueous or organic solutions of the $AlCl_3$ salt, and similar structures with ions such as $Cd^{2+}$, $Fe^{3+}$, $Zr^{4+}$, $Ti^{4+}$, $Cu^{2+}$, $Cu^+$, $Ag^+$. Structures with carboxylate-$Fe^{3+}$-carboxylate interlayer binding have also been constructed, as well as structures with alternate layers of different ions, such as phosphate-$Al^{3+}$-carboxylic acid and phosphate-$Ca^{2+}$ carboxylic acid (see Fig. 5b).

Example 2: Superlattice Structures of Organic Chromophoric Molecules with Intra and Interlayer Intercalated Inorganic Ions

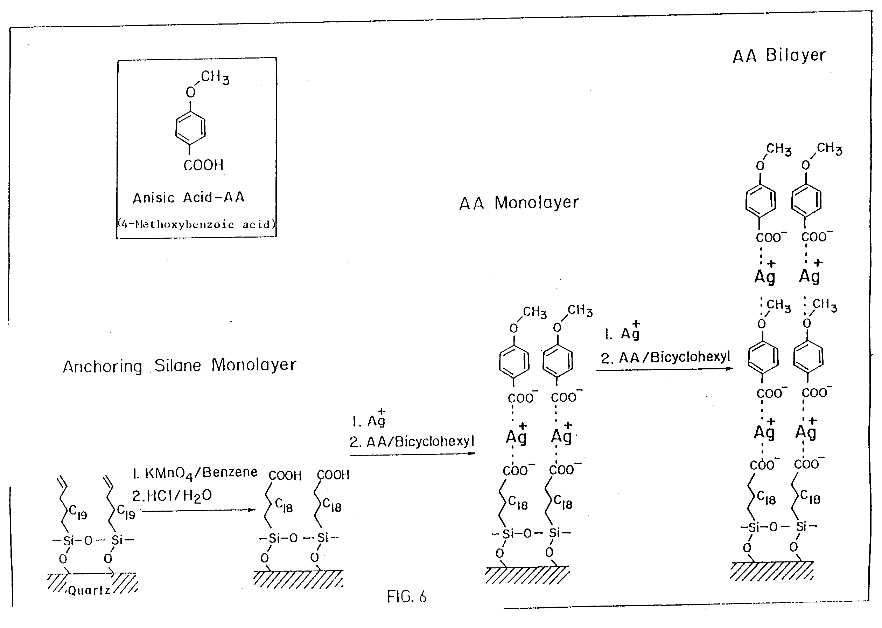

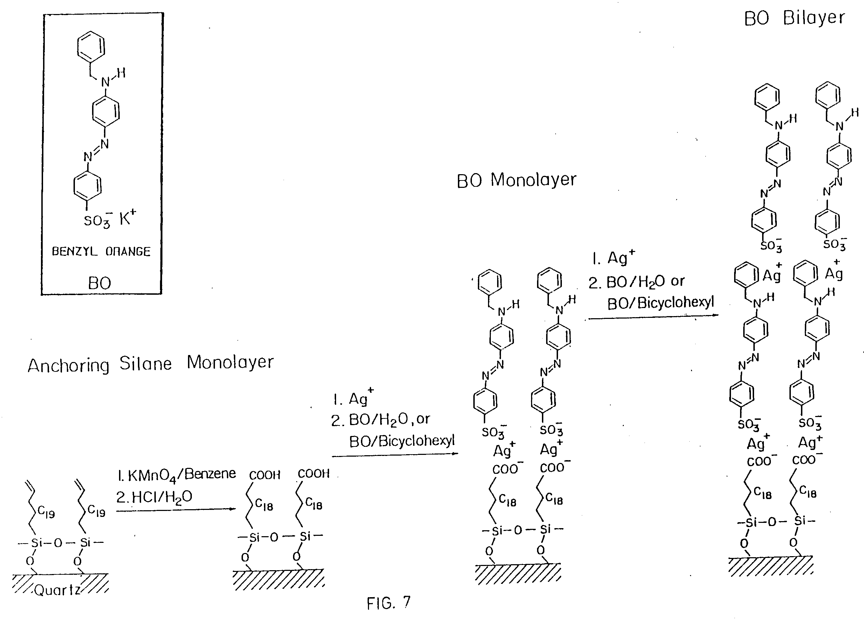

Two examples of chromophoric superlattices containing metal ions, constructed by chemically controlled self-assembly, are illustrated in Figs. 6 and 7, depicting schematically the controlled assembly of multilayers of anisic acid (AA) (4-methoxybenzoic acid) and benzyl orange (BO), [4-(4-benzylaminophenylazo) benzenesulfonic acid], respectively, with inter and possibly intralayer binding mediated by $Ag^+$ ions. Each $Ag^+$ ion may bind four, or even more ligands, in a planar or tetrahedral configuration. The layer-by-layer deposition process in these chromophoric superlattices starts with an "anchoring" silane-terminal ethylenic double bond monolayer, continues with the in situ chemical modification converting the double bonds to terminal carboxylic acid functions, and proceeds through the alternate deposition of layers of $Ag^+$ ions using a soluble silver salt and layers of the respective chromophores. The first $Ag^+$ layer binds to the exposed -COOH functions of the anchoring silane monolayer as silver carboxylate salt species, while each of the next deposited $Ag^+$ layers adheres to the outer exposed surfaces of the chromophoric layers via coordination, complex formation, with either the outer ether oxygens of AA (Fig. 6) or the outer amino and possibly phenyl groups of BO (Fig. 7). Each layer of chromophores binds to a previously deposited outer $Ag^+$ layer as the respective silver sulfonate salt.

It should be noted that the inter-intralayer binding in both the AA and BO systems proceeds through moieties which are integral parts of the respective chromophores themselves. This implies, as mentioned above, that the resulting superlattices are actually composed of modified chromophoric species, in which $Ag^+$ ions are attached to both extremities of each chromophore. Charge redistribution is expected to occur in these silver-"sandwiched" chromophores, leading to significant differences in their spectral, optical, and electronic properties, as compared with the respective silver-free species.

Finally, it should also be noted that except for the first $Ag^+$ layer, binding to the $-COO^-$ ionic functions of the anchoring monolayer, electrical charge neutrality requires the presence of a negative counter ion for each $Ag^+$ ion coordinated by neutral ether oxygen or amino groups. Deposition of layers of such ionic species must thus involve a surface ion-exchange process, each layer of ionic chromophores (sulfonates, in this particular case) replacing an equivalent layer of surface attached negative counter ions. This further implies that surface-bound ionic chromophores should also be replaceable by other negatively charged species.

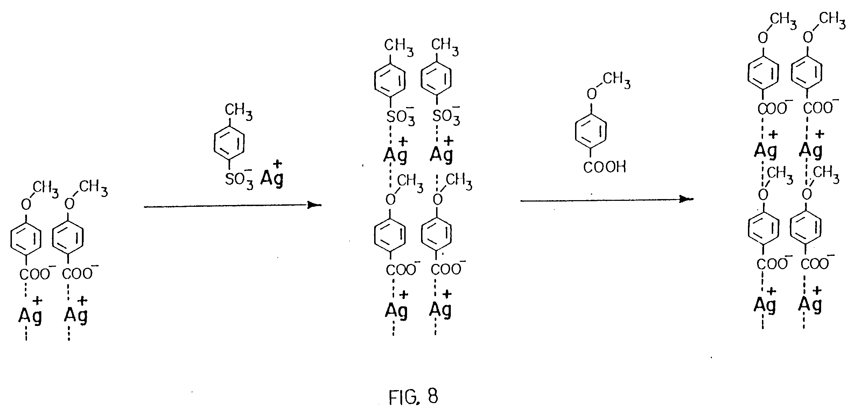

Experimental evidence confirming this ion-exchange mechanism was obtained using ionic species that may be detected spectroscopically through their specific absorbance in the UV-Vis or IR regions. For example, Fig. 8 shows schematically the actual surface ion exchange process employed in the construction of the $AA-Ag^+$ and $BO-Ag^+$ superlattices of Figs. 6 and 7. The silver salt utilized in these examples is that of the p-toluene sulfonate (PTS) chromophore, which forms an oriented self-assembly monolayer with molecular packing identical or very similar to that of the AA or BO chromophores. One layer of PTS is replaced by one layer of AA or BO molecules, as depicted in Fig. 8, while uncontrolled multilayer formation of $Ag^+$-PTS species is not possible since $Ag^+$ cannot bind to the outer $-CH_3$ groups of the oriented toluene moiety. PTS serves, therefore, as a convenient and easily displaceable $Ag^+$ carrier, enabling the controlled deposition of well defined monolayers of the silver metal ion, in alternation with well defined monolayers of a suitable layer-forming chromophore.

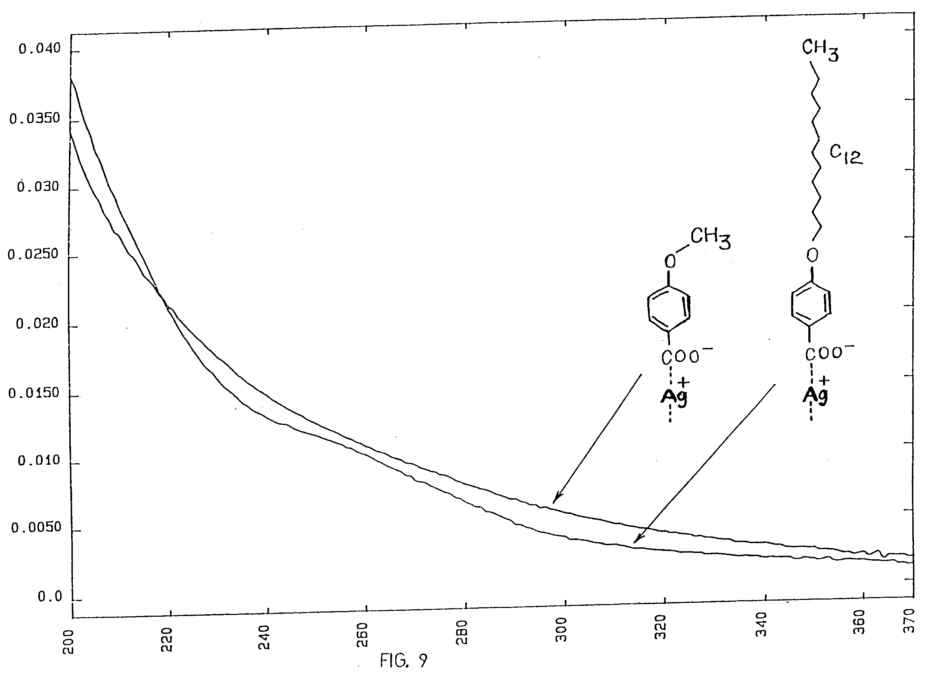

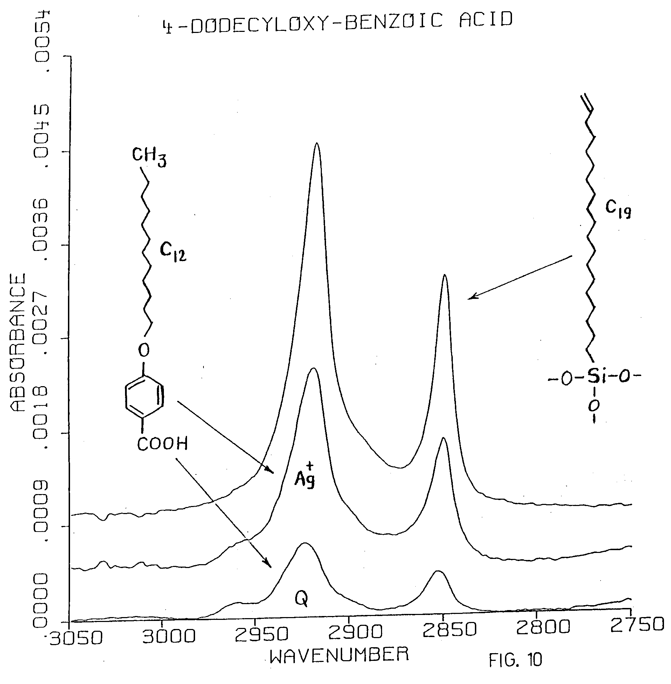

The layer-by-layer deposition process as well as the surface density and orientation of the chromophores in the resulting multilayer structures depicted in Figs. 6-8 have been followed using contact angle measurements and FTIR and UV-Vis spectroscopies in various surface-adapted configurations, also including dichroic measurements with linearly polarized radiation. For example, Figs. 9 and 10 display the UV and IR absorbance spectra recorded for one layer of $AA-Ag^+$ and one layer of a long-chain-substituted ($C_{12}$ - carbon atoms) $AA-Ag^+$ analog (4-dodecyloxybenzoic acid-DDBA), deposited on an anchoring silane monolayer on quartz. The spectra are corrected for the absorbance of the anchoring monolayer and the quartz slide below about 220 nm. The AA and the $C_{12}$-

substituted chromophores can repeatedly replace each other on the $Ag^+$-treated surface (of the anchoring monolayer), via the above-described ion-exchange process, the exchanged layers displaying very similar UV absorbance curves (Fig. 9), which implies similar molecular packing and orientation of the respective chromophores on the surface, but significantly different contact angles, as expected on the basis of the different chemical constitution of the outer exposed surfaces produced by each of these components. The $C_{12}$ hydrocarbon chain of the long-chain-substituted chromophore serves as a convenient IR and contact angle marker, allowing the evaluation of the molecular density of this compound on the surface.

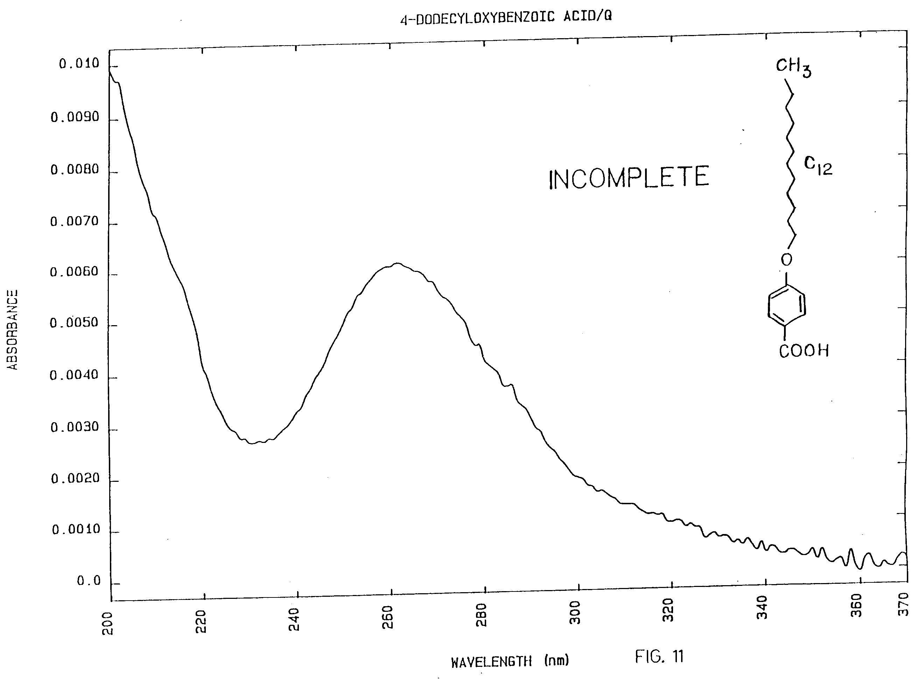

Thus, the contact angles measured on the $AA-Ag^+$ layer of Fig. 9 were 32° for BCH, 30° for HD, 73-75° (advancing) and 65° (receding) for $H_2O$, while those measured on the corresponding $DDBA-Ag^+$ layer were 51-52° for BCH, 42-44° for HD and 108-109° for $H_2O$ (no detectable hysteresis). In the IR (see Fig. 10), a comparison of the integrated intensities of the ($-CH_2-$) stretching bands around 2900 $cm^{-1}$ in the spectra of the anchoring silane monolayer [17($-CH_2-$) units, about 20 $Angstrom^2$/molecule] and the layer of the $C_{12}$-substituted chromophore [11-$CH_2-$) units] points to a remarkably tight packing of the latter (about 21-22 $Angstrom^2$/chain), which would be possible only with the chromophores oriented perpendicularly on the surface. If the same DDBA chromophore is adsorbed as the free acid on a bare quartz surface, i.e., with no $Ag^+$ ions attached to an anchoring monolayer, it forms an incomplete monolayer containing only 37% of the material present in the respective tightly packed layer, as shown in the lower curve in Fig. 10, and its UV spectrum, illustrated in Fig. 11, displays a prominent peak around 260 nm, as expected for such chromophores in a parallel orientation on the underlying surface. No such peak appears in the UV spectra of perpendicularly oriented $AA-Ag^+$ chromophores. Accordingly, the contact angles of this incomplete layer were very low -28° for BCH, 19° for HD and 49° for $H_2O$.

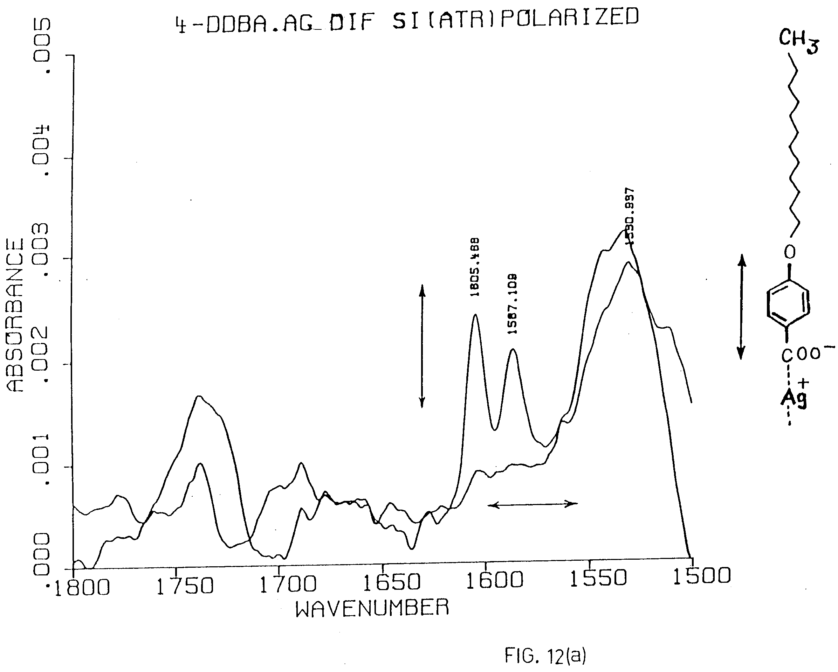

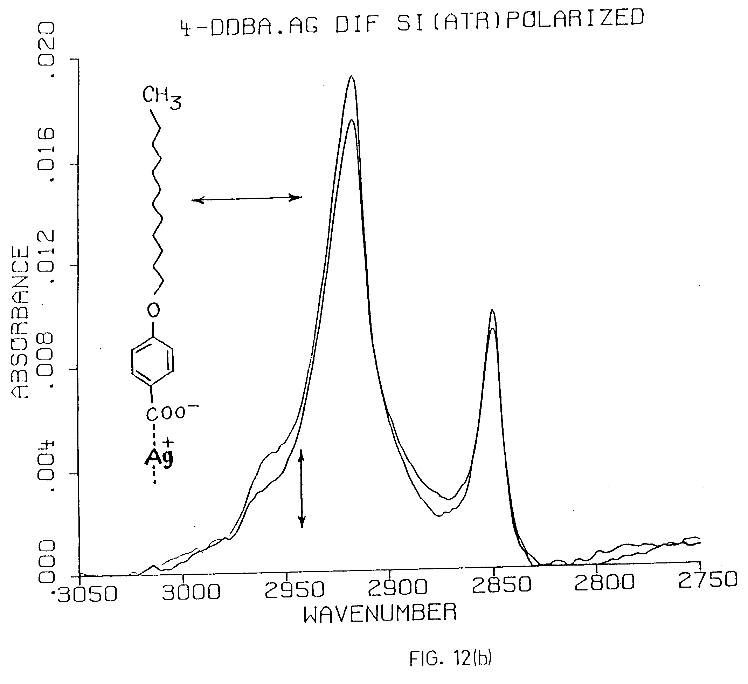

Further evidence for the perpendicular orientation of the $AA-Ag^+$ and $DDBA-Ag^+$ chromophores in the complete monolayers comes from FTIR-ATR polarized (dichroic) measurements on silicon. In Fig. 12, the two curves represent measurements with the polarization parallel to the layer plane (←→) and the polarization having both parallel and perpendicular components (↕), respectively, and are net contributions of the aromatic monolayer (after subtracting the spectral contributions of the anchoring monolayer and the Si substrate). For the sake of clarity, the spectral regions 1800$cm^{-1}$ to 1500$cm^{-1}$ and 3050 $cm^{-1}$ to 2750$cm^{-1}$ are shown

at different scales, in Fig. 12(a) and 12(b), respectively. The aromatic vibration modes at 1605 cm$^{-1}$ and 1587 cm$^{-1}$, pointing in the direction of the para substituents, are present in the polarization mode having both in-plane and out-of-plane components, while they are very weak, or not detectable at all, in the polarization parallel to the surface. On the other hand, the chain (-CH$_2$-) stretch modes around 2900 cm$^{-1}$ appear with almost equal intensities in both polarizations, as expected for such vibrations parallel to the surface, corresponding to a perpendicular orientation of the chains [see R. Maoz and J. Sagiv, J. Colloid Interface Sci. 100, 465 (1984)].

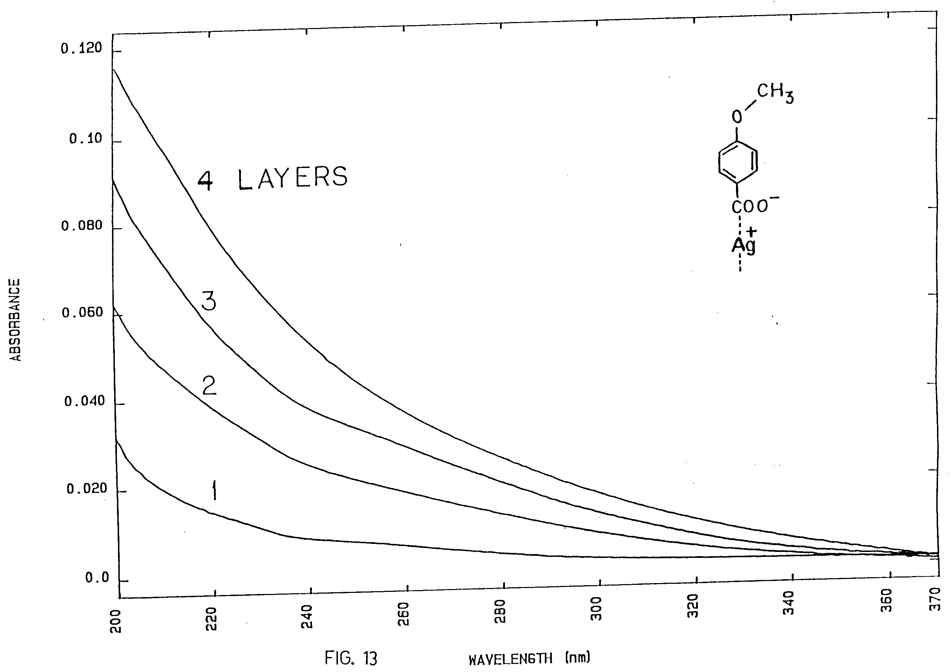

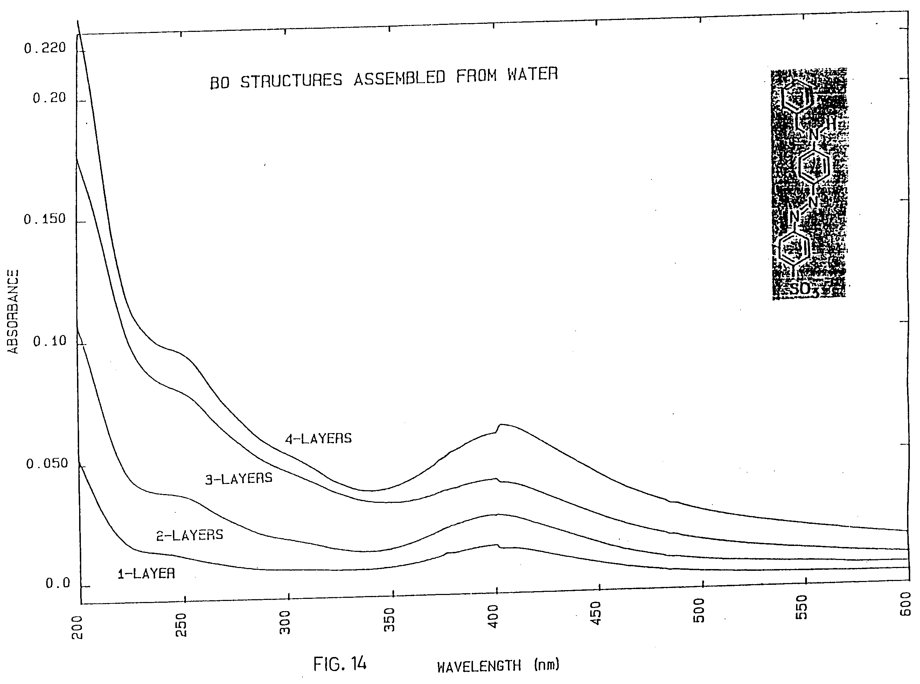

The layer-by-layer growth in thickness of 4-layer superlattices of perpendicularly oriented AA-Ag$^+$ and BO-Ag$^+$ was demonstrated by UV-Vis spectroscopy, as shown in Figs. 13 and 14, respectively.

These AA and BO chromophoric superlattices were constructed as non-centrosymmetric structures, with polar axes pointing along the normal to the layer planes. Polar films of this type are expected to display piezo and pyroelectricity as well as non-linear optical effects, such as second-harmonic-generation (SHG). Preliminary SHG measurements confirmed this expectation, also providing additional evidence for the preferential perpendicular orientation of the chromophores in these AA-Ag$^+$ and BO-Ag$^+$ multilayer structures.

Construction of the AA-Ag$^+$ Multilayer Structures shown in Fig. 6 proceeded as follows. Synthetic quartz slides (Westdeutsche Quarzschmelze, synsil poliert, 37.5x12x1 mm) were activated (cleaned) for adsorption by 30 minutes extraction with boiling toluene in Soxhlet extractor, followed by 10-20 minutes exposure to argon plasma in a RF discharge apparatus. The anchoring silane monolayer was prepared via the KMnO$_4$-crown ether oxidation of the terminal double bonds of a C$_{19}$-silane-terminal double bond monolayer, using the following procedure:

The silane monolayer was adsorbed on the activated quartz slide from a 2.0 x 10$^{-1}$ M solution of 18-Nonadecenyltrichlorosilane (NTS) in BCH at ambient temperature, by repeating 3 times an adsorption-extraction cycle consisting of 15 minutes immersion in the silane solution followed by 10 minutes extraction with boiling toluene in a Soxhlet extractor, after which the slide was subjected to 4 cycles, each consisting of 8-12 hours immersion in the silane solution and 15 minutes Soxhlet extraction with toluene, and final Soxhlet extraction with toluene for 30 minutes. The silane solution was replaced with a freshly prepared solution after each of the adsorption cycles. This thorough adsorption-extraction process ensured formation of very reproducible, high quality silane monolayers, in terms of the perfection of surface coverage and regularity of molecular orientation and packing, as well as the layer's resistance to desorption by various solvents. Such high quality NTS monolayers display very high characteristic contact angles: 50° for BCH, 48° for HD, 104° for H$_2$O, no hysteresis. The above described procedure, involving extraction with boiling toluene, for the production of high quality silane monolayers is applicable to substrates such as glass, quartz, silicon, metals, but not to ZnSe, from which silane layers are partially desorbed upon prolonged exposure to boiling toluene. In such cases, rinsing with toluene at ambient temperature should be applied.

The slide coated with the silane monolayer was immersed for 10-12 hours in a 1.0 x 10$^{-3}$ M benzene solution of equimolar quantities of KMnO$_4$ and dicyclohexano-18-crown 6 (Sigma, 98%) at ambient temperature, after which it was rinsed with toluene, followed by 10 minutes Soxhlet extraction with boiling toluene. This reaction-rinse-extraction cycle was repeated for additional three times (total reaction time - about 44-48 hours), each cycle starting with a fresh KMnO$_4$-crown ether solution. Finally, the slide was immersed for 10 minutes in a 5% solution of HCl in double distilled water at ambient temperature, followed by 10 minutes Soxhlet extraction with boiling toluene. The characteristic contact angles measured on freshly prepared carboxylate (-COO$^-$K$^+$) outer surfaces prepared by this procedure are 0° (wetted by all three liquids), and on carboxylic acid (-COOH) surfaces -40° for H$_2$O (no hysteresis), and 0° for BCH and HD.

The first AA layer was deposited on the activated anchoring silane monolayer by the following 2-step process: (1) immersion of the slide for 1 hour in a 5 x 10$^{-3}$ aqueous solution of Ag$^+$-p-toluenesulfonate Ag$^+$-PTS, Aldrich, 99+%) at ambient temperature, followed by (2) immersion for 10 minutes in a 5 x 10$^{-4}$ M solution of p-Anisic Acid (BDH, 99+%) in BCH/CHCl$_3$ (2% CHCl$_3$) at ambient temperature. Additional AA layers were adsorbed on top of the first deposited layer in a similar fashion, the adsorption time of Ag$^+$-PTS being, however, equal to that of AA (10 minutes).

A number of other model superlattice structures with organic chromophores and inorganic metal ions have been constructed, including: structures similar to those of Figs. 6 and 7, but with methyl orange [4-(4-dimethylaminophenylazo) benzenesulfonic acid] (MO) instead of BO; similar structures, but with silver benzoate or AgNO$_3$, instead of Ag$^+$-PTS, as silver ion carrier; similar structures, where the anchoring monolayer is a long chain silane with a terminal thiol (-SH) function; similar structures, but with Cu$^{2+}$, Cu$^+$, or Fe$^{3+}$ ions rather than Ag$^+$; BO-Ag$^+$ multilayers assembled from either organic or aqueous solutions of BO, with aqueous Ag$^+$-BO species serving as the silver ion carrier (i.e., the layer deposition process proceeding through alternate immersions in aqueous solutions of the $Ag^+$-BO salt and organic or aqueous solutions of the neutral BO); multilayers of 4-vinyl benzoic acid or 4-vinyl benzene sulfonate and $Ag^+$ (with the $Ag^+$ ion adhering to the outer vinyl functions through formation of the $Ag^+$-ethylenic double bond complex); multilayers of p-terephthalic acid and $Fe^{3+}$; superlattices in which AA-$Ag^+$ layers alternate with p-nitroaniline-$Al^{3+}$ layers, with the aluminum ion introduced from aqueous solution of $AlCl_3$; multilayers of AA-$Cu^+$ formed on ZnSe without the need of an anchoring monolayer, i.e., through direct ionic bonding of the first deposited AA monolayer to the ZnSe surface, as the $Zn^{2+}$-AA salt, AA-$Ag^+$ multilayers as in Fig. 6, but constructed on a silver metal surface, without an anchoring monolayer.

Additional examples of superlattices containing organic chromophores and inorganic ions, that can be produced by chemically controlled self-assembly are listed below: Disk-like aromatic molecules such as benzene, coronene, pyrene, naphtodianthracene and their derivatives, porphyrine and derivatives, phthalocyanine and derivatives, crown ethers, and many others, may be used as components in superlattices with intercalated metal ions. The binding of the metal ion to flat aromatics of this kind will be via complexation and/or salt formation with the aromatic rings themselves and/or their substituents. Such disk-like chromophores play the double role of both their own binding functions and latent binding functions, their symmetry forcing them to adopt a flat orientation on the surface, i.e., with the aromatic planes parallel to superlattice layer planes. Other possibilities include the use of cationic organic chromophores, such as anilinium or pyridinium species and their derivatives, with intra and/or interlayer inorganic anionic species. Structures made of ionic chromophores of both cationic and anionic type, with or without the participation of inorganic counter ions, are also possible. Finally, construction of a large variety of chromophoric superlattices combining different organic chromophores and inorganic ionic species, in various mixed or intercalated configurations, is feasible through chemically controlled self-assembly.

## Example 3: Superlattice Structures Combining Organic Molecules with Inorganic Semiconductor and Metal Components

The composite superlattices suggested by Fig. 15 serve to illustrate the general principles involved in the assembly of such organic-semiconductor and related structures. There are, of course, many other possible chemical routes complying with the general requirements of chemically controlled self-assembly which can be employed in the construction of various superlattices of this kind. A large variety of semiconductor and organic materials may be employed as well as chemical procedures for the coupling of the organic and the inorganic species.

For example, utilization of cyclic or polycyclic aliphatic compounds such as derivatives of adamantane, instead of long chain amphiphiles, is possible. Sulfur may be coupled to hydrocarbons through any useful synthetic route leading to the formation of thiols, sulfides and disulfides, such as the photo-addition of thioacetic acid to terminal double bonds followed by reduction with $LiAlH_4$, or substitution of terminal halide atoms (Cl, Br) by -SCN, or by thioacetic acid, followed by reduction with $LiAlH_4$. Cadmium ions may be replaced by $Zn^{++}$ or $Ag^+$, leading to the formation of zinc sulfide or silver sulfide species, sulfur may be replaced by Se or Te, resulting in the respective selenides or telurides, and so on. Utilization of chromophoric species such as vinyl benzene (styrene) derivatives is also possible, leading to superlattices with intercalated semiconductor and organic layers of chromophores. Finally, the build-up process of Fig. 15 may be reversed, by first binding the metal ion to a suitable organic monolayer and then attaching the selected chalcogenide or other inorganic anionic species.

By analogy with the build-up process of Fig. 15, replacing the semiconductor by pure metal layers will result in analogous superlattices with combined organic and metallic constituents. This may be achieved by the chemical, photochemical or electrochemical reduction of layers of the desired metal ion, using any suitable reducing agent. For example, $Ag^+$ ions bound to an organic layer by complexation with double bonds, halide atoms or aromatic moieties, or as salts of anionic moieties such as carboxylates (-$COO^-$) or sulfides (-$S^-$), may be reduced photochemically to the $Ag^0$ metal by exposure to electromagnetic radiation in the visible-UV-X ray regions, or by reaction with an aldehyde or any other suitable reducing agent (such as those usually employed in the photographic image development), or by electrochemical means, provided the superlattice is electrically conducting or is constructed on an electrically conducting substrate. Similar electroless or electrochemical reduction processes may be applied to the controlled deposition of monolayers of Au, Cu, or any other metal of interest.

One-by-one deposition of monolayers of a selected metal species is achieved by adsorbing a new layer of the metal ions onto the last layer of reduced metal, reducing this new layer of ions by an analogous reduction procedure, and repeating these adsorption and reduction steps until the desired metal film thickness, or number of superimposed metal monolayers, is achieved. In such metal deposition processes one may identify the reduction step with the chemical "trigger" operation of Fig. 2. The conversion of each monolayer of metal ions to the respective metal element is required to promote the adsorption of a new layer of metal ions on top of it. Intercalation of metallic layers of interest with organic layers of selected species results in composite superlattices combining layers of various organic molecules and metal elements. Superlattice structures of higher structural and compositional complexity may be obtained by intercalating layers of selected metals, semiconductors and organic species.

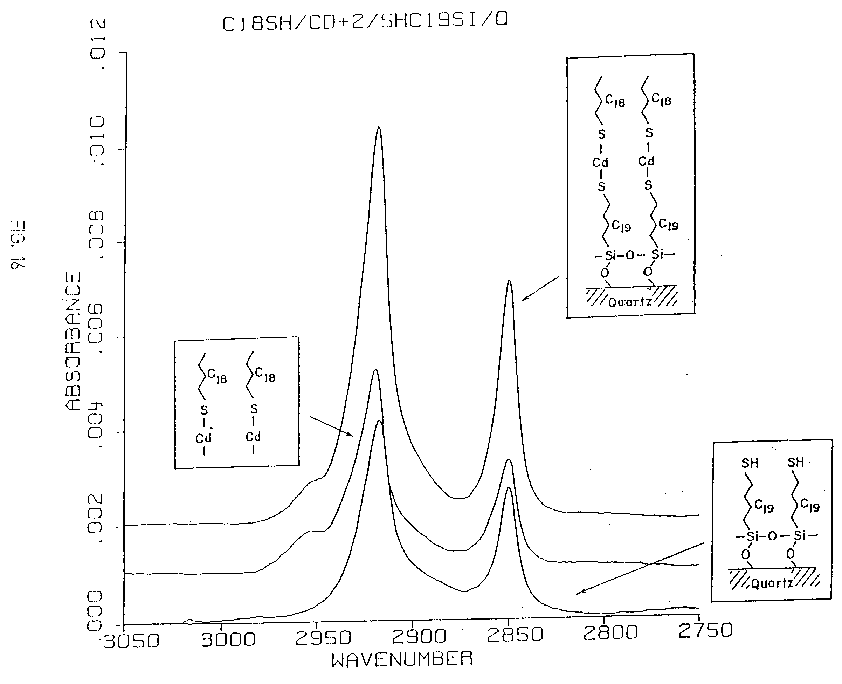

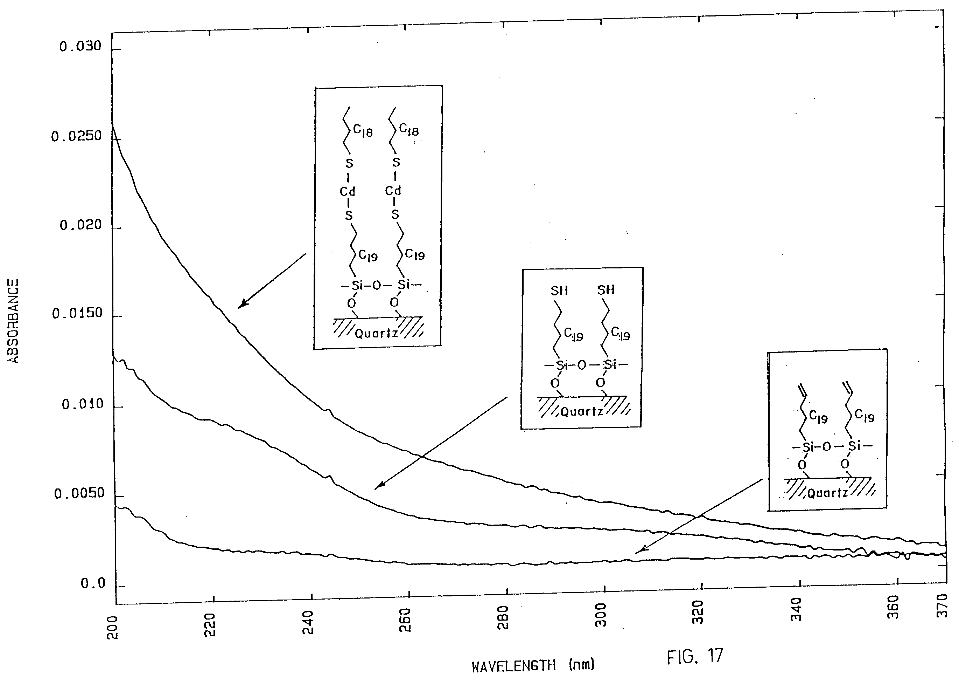

In one experiment a trilayer structure consisting of one layer of CdS intercalated between 2 organic layers of long chain amphiphiles (with 19 and 18 carbon atoms, respectively), was constructed on a quartz slide. This is evidenced by UV and IR spectra taken after each step during the deposition of these layers (Figs. 16 and 17), as well as by the corresponding contact angles (see below). The IR data (Fig. 16) provide quantitative evidence for the presence of the organic layers, while the UV spectra (Fig. 17) clearly indicate the sequential introduction of the sulfur and cadmium species. As expected for an ultrathin, possibly discontinuous layer of CdS species, the UV spectra in Fig. 17 differ from the characteristic spectrum of the bulk semiconductor. Thus, the curves in Fig. 17 are considerably blue- shifted relative to that of the bulk CdS (adsorption onset at ca. 540 nm), pointing to a possible quantum-size effect similar to that observed with small colloidal particles of this material.

In this experiment, a $C_{19}$-silane-terminal double bond (NTS) monolayer was adsorbed on an activated quartz slide from a solution of NTS in BCH using the same procedure as described above in connection with the preparation of the anchoring silane monolayer of AA-Ag$^+$ multilayer of Fig. 6.

The monolayer coated quartz slide was introduced in a quartz tube connected to a cylinder of pure $H_2S$ gas (Matheson), purged for approximately 10 minutes with $H_2S$, and then irradiated for about 2.5 hours with a UV lamp producing radiation at a wavelength of 254 nm, while maintaining positive pressure of $H_2S$ in the quartz tube during the UV radiation. A thin layer of bulk sulfur was deposited on the slide, becoming visible to the eye by the end of the irradiation period. The slide was then rinsed in cold toluene, to remove the bulk sulfur coating, and finally extracted for approximately 15 minutes with boiling toluene in a Soxhlet extractor.

$Cd^{2+}$ ions were attached to the $H_2S$-reacted monolayer surface by immersing the slide for 30 minutes in a $1.0 \times 10^{-3}$ M solution of $Cd^{2+}$-acetate (BDH, Analar) in double distilled water, at ambient temperature.

Finally, a $C_{18}$-thiol monolayer was adsorbed on the $Cd^{2+}$-treated surface by immersing the slide for 10 minutes in a $5.0 \times 10^{-3}$ M solution of n-octadecylthiol (Fluka, 95%, twice recrystallized from methanol) in BCH at ambient temperature, followed by rinsing with cold toluene.

Characteristic contact angle variations, as expected from the specific changes in chemical constitution and polarity of the exposed outer film surface, were measured after each adsorption and/or reaction step during the construction of this trilayer structure as follows:

Initial $C_{19}$-silane-terminal double bond monolayer:
BCH: 51°; HD: 47°; $H_2O$: 105-103°, no hysteresis.
$H_2S$-reacted monolayer:
BCH: 0°; HD: 0°; $H_2O$: 35°, no hysteresis.
$Cd^{2+}$-treated monolayer:
BCH: 0°; HD: 0°; $H_2O$: 56°, no hysteresis.
Trilayer structure (after deposition of the $C_{18}$-thiol monolayer):
BCH: 52°; HD: 46°; $H_2O$: 113°, no hysteresis.

Example 4: Post-Assembly Intercalation and/or Chemical Modification

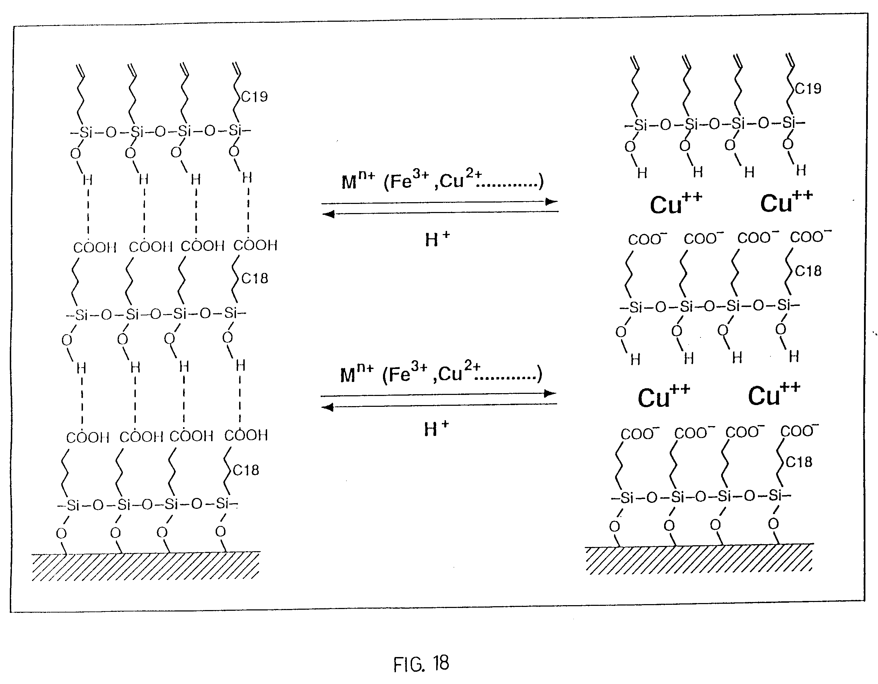

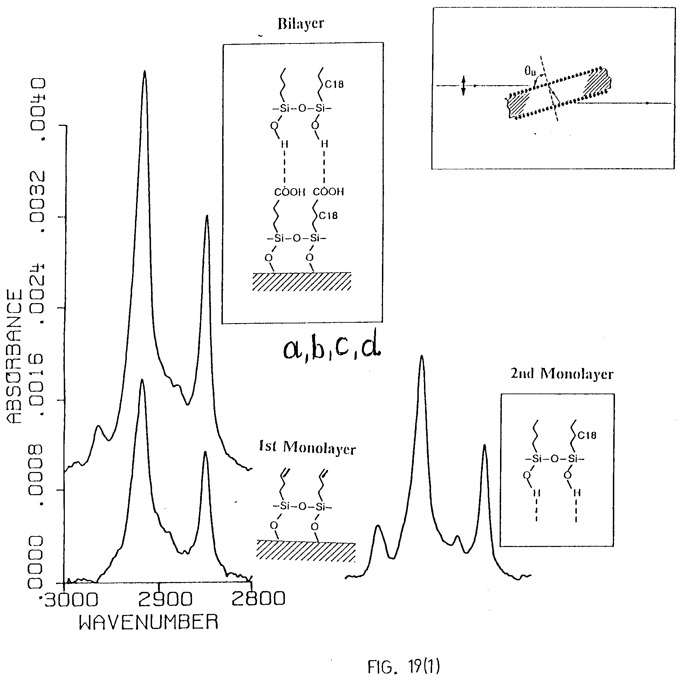

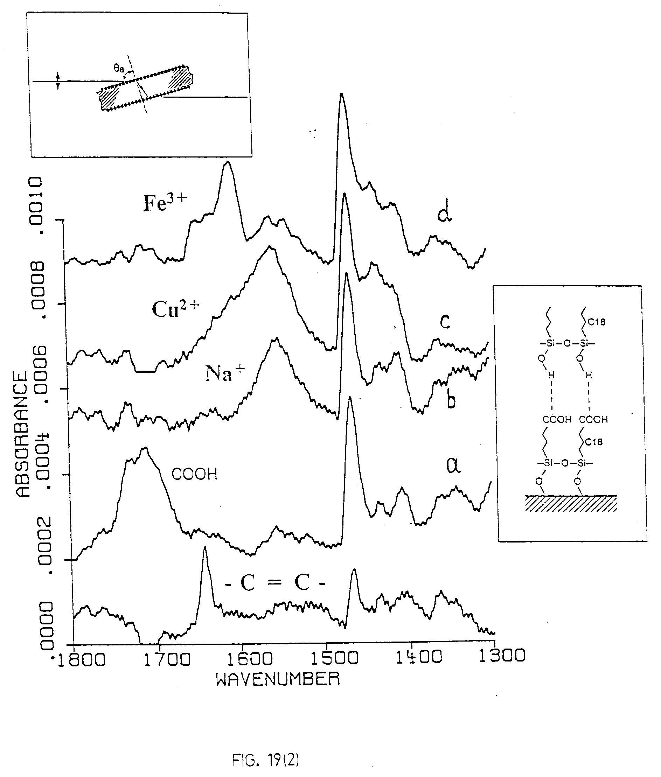

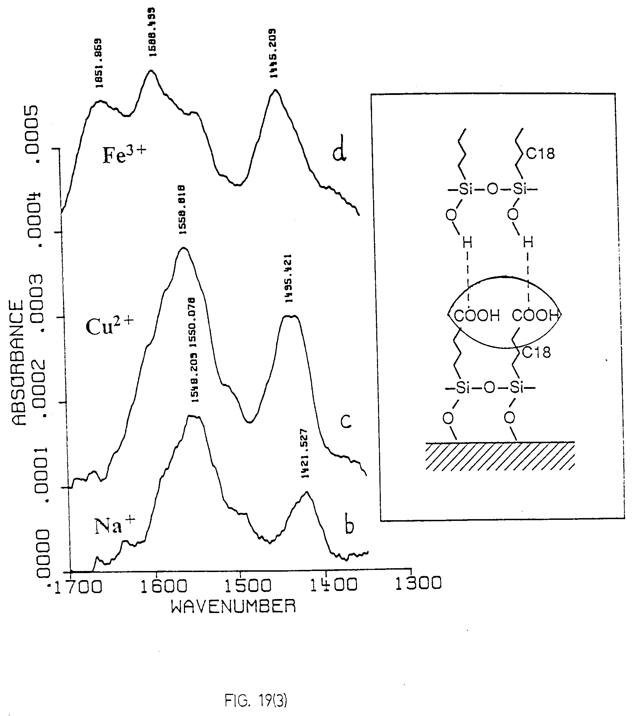

Post assembly intercalation is illustrated below with a simple example comprising intercalation of mobile metal ions into a hydrogen-bonded multilayer structure with fixed carboxylic acid (-COOH) groups in the interlayer planes (Fig. 18). Fig. 19 illustrates IR spectra showing quantitative conversion of the free -COOH groups into carboxylates (-COO$^-$) of Na$^+$, Cu$^{2+}$, and Fe$^{3+}$, upon immersion of the initial superlattice into aqueous solutions of the respective ions. No change in the C-H vibrations of the hydrocarbon chains was observed [Fig. 19(1)], pointing to the overall high structural stability of the initial superlattice upon exchange of the mobile ionic species. This conclusion is further corroborated by the constant contact angles measured on the outer film surface, before and following ion intercalation.

Hydrogen-bonded superlattices of the kind depicted in Figs. 18 and 19 have been assembled using two different synthetic routes:

(a) Slow Build-Up Process

This process is similar to that described before in connection with Figs. 3(g) and 4 described above. However, the present process takes place under conditions leading to the formation of interlayer hydrogen bridges rather than covalent silane-ester linkages. The particular mode of interlayer bonding adopted by the system is determined, in this case, by the hydrophilicity/hydrophobicity of the outer exposed carboxylic acid layers. Thus, final rinse of the outer -COOH layer with $H_2O$, before adsorption of the next silane layer, induces very fast siloxane (-Si-O-Si-) polymerization, taking only seconds, with formation of interlayer hydrogen bridges, while extraction with toluene, causing moderate hydrophobicity of the outer -COOH layer, results in a slower siloxane polymerization, taking several minutes, with the concomitant formation of covalent ester interlayer bonds.

### (b) Fast Build-Up Process

Rapid conversion of monolayer terminal double bonds to terminal carboxylic acid functions is conveniently achieved by the $FeCl_3$-catalyzed photo-oxidation of the double bonds, with $O_2$ in aqueous $FeCl_3$. In a typical procedure, the mono/multilayer covered substrate is immersed in an oxygen-saturated aqueous solution of $FeCl_3$ ($1.0 \times 10^{-3}$ M) at ambient temperature and then irradiated for 1-3 minutes with a halogen lamp (visible light) under continuous bubbling of pure $O_2$ gas. The resulting $Fe^{3+}$-carboxylate functions are converted to the free acid (-COOH) by immersion in concentrated aqueous HCl for several seconds. Finally, the reacted surface is rinsed with pure water and dried in a stream of clean nitrogen or argon. Irradiation with other visible or near-UV light sources, including natural sun light, or a "black light" (RUL-3500 Angstrom) lamp, gives similar results. The use of air instead of pure $O_2$ is also possible, but results in a somewhat slower reaction.

Carboxylic acid outer surfaces produced by this procedure are suitable for fast formation of polymerized hydrogen-bonded silane monolayers, as described above. The self-assembly of such silane monolayers is complete within seconds following immersion of the coated substrate into the solution of the selected monolayer-forming silane.

Hydrogen-bonded multilayer structures such as those depicted in Fig. 18 have been successfully assembled by this fast photo-oxidation fast monolayer formation process at a rate of less than 5 minutes per monolayer. The process involves simple preparative conditions, and is easily adaptable to automation as well as large scale production.

Both the formation of hydrogen-bonded silane monolayers and the process of ion intercalation proceed through mechanisms involving lateral diffusion of mobile species over the entire available surface area of the solid substrate. This eliminates the need for complete immersion of the substrate in the respective solutions, identical final results being obtained by merely touching the solution with one edge of the substrate and using the solution/substrate contacts established along the immersed substrate edge. This feature is particularly important in the application of the present superlattice materials in uses such as microchromatography and electrophoresis, microsensor devices, and similar applications.

### Additional Examples of Post-Assembly Intercalation/Chemical Modification Processes

A series of intercalation experiments, including ions uptake, extraction and exchange, were conducted with hydrogen-bonded superlattices of the kind depicted in Fig. 18 using various ions, such as $Na^+$, $K^+$, $Ag^+$, $Cu^{2+}$, $Fe^{3+}$, $Al^{3+}$, organic cyanine dyes (cationic).

The results indicate remarkable qualitative differences between the uptake rates of the various tested ions. For example, complete conversion of the free -COOH functions into the respective metal carboxylates, over a film length of approximately 5 cm above the substrate contact line with the solution of the metal ion, was found to require approximately 3 hours for $K^+$, approximately 50 minutes for $Na^+$, about 10 minutes for $Fe^{3+}$, a few minutes for $Al^{3+}$, and seconds for $Cu^{2+}$ or $Ag^+$.

Reversible exchange of ions between intercalated and solution species was also easily accomplished, the process depending on the nature of the counter ions (anions) found in solution. For example, the exchange of intercalated $Ag^+$ with $Cu^{2+}$ from an aqueous $Cu(NO_3)_2$ solution is very fast, while practically no exchange occurs with $Cu^{2+}$ from aqueous $Cu(Ac)_2$. Diffusion of ions into and out of the superlattice interlayer spaces is blocked, in this case, by the formation of a thin barrier of insoluble silver acetate at the superlattice-solution boundaries.

The feasibility of "superlattice-within-superlattice" formation has been tested with a complex system comprising an initial hydrogen-bonded superlattice of the kind depicted in Fig. 18, which has been successively exposed to aqueous solutions of glucose and $Ag^+$-p-toluenesulfonate ($Ag^+$-PTS).

IR spectral data collected after completion of each of the above operations indicate discrete, layer-by-layer, uptake of glucose and silver ions, with the apparent layer-by-layer reduction of $Ag^+$ to metallic silver and the corresponding oxidation of interlayer incorporated glucose. The alternate uptake of glucose and silver ions falls within the general definition of a chemically controlled self-assembly process (Fig. 2), as each new layer of glucose is added only following the deposition of a layer of silver ions, and vice versa. Both glucose and silver layers are intercalated into the interlayer spaces of the initial superlattice the overall process thus involving sequential post-assembly intercalation combined with further chemical modification through the redox reaction of the intercalated glucose and $Ag^+$ species.

A large variety of complex intercalation processes is feasible, using complex superlattices and more than one intercalable species. For example, cations, anions and neutral species may be simultaneously intercalated into various predetermined interlayer spaces of the initial superlattice, according to the nature of fixed ionizable groups and the specific chemical affinity of other fixed chemical moieties, neutral or charged, present in the respective spaces. Simultaneous as well as sequential intercalation from one or more fluid and/or solid phases is also possible.

Further examples of post-assembly chemical modifications of composite superlattices are the in situ generation of metal or semiconductor layers of the types mentioned above, the present process allowing simultaneous conversion of all superlattice layers, or a selectable portion thereof, into the desired product, rather than its step-by-step generation, as described above. Thus, intercalated metal ions such as $Cd^{2+}$, $Zn^{2+}$, $Cu^{2+}$, $Ag^+$, and others, may combine with $H_2S$, $S^{2-}$, $HS^+$, or similar Se or Te species diffusing from an outer liquid, gas or solid phase, to form the respective sulfides, selenides or telurides simultaneously in all metal ion-containing layers of the superlattice.

Similarly, metal layers, such as Ag, may be produced by the simultaneous reduction of any number of $Ag^+$-containing layers of a preassembled superlattice into the free metal element. As described above, the reduction may be carried out photochemically, electrochemically, or chemically, with reducing agents diffusing into the $Ag^+$ superlattice layers, or via electron transfer from reducing agents located in adjacent layers of the superlattice, or reducing agents located in an outer fluid or solid medium, including the superlattice substrate.

While the invention has been described with respect to a limited number of preferred embodiments, it will be appreciated that many variations, modifications and other applications of the invention may be made.
Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

**Claims**

1. A controlled self-assembly process for the production of a composite organic-inorganic superlattice structure attached to a solid substrate, said structure comprising discrete monolayers of organic, inorganic and/or organic-inorganic species, the method comprising:

   (a) forming a first discrete monolayer on the solid substrate by spontaneous adsorption/chemisorption of the layer constituents from an adjacent fluid, under conditions preventing self-adherence of the layer constituents on top of said first monolayer; and

   (b) triggering sequential deposition of additional discrete monolayers in a discontinuous, stepwise manner, each layer being formed by spontaneous adsorption/chemisorption of the layer constituents from an adjacent fluid, such that in each step self-adherence of the layer constituents on top of the respective layer is prevented.

2. A process according to claim 1 wherein the triggering is accomplished by modifying the chemical nature of a latent binding function of the exposed outer surface of the last deposited layer into an active binding group enabling the adsorption/chemisorption on top of it of an additional discrete monolayer of a desired species.

3. A process according to claim 1 wherein the triggering is accomplished by alternating the deposition of layers of different species such that the species have adequate affinity to each other so that the exposed outer surface of a monolayer of one of the species enables the adsorption/chemisorption on top of it of an additional discrete monolayer of the other species.

4. A process according to claim 3, wherein the modification of the exposed outer surface of the last deposited layer is effected by any operation or sequence of operations involving a chemical, photochemical, or electrochemical process or reaction, including those mediated by chemical reagents, electrical current, electromagnetic radiation, electric or magnetic field, electron or ion beams, electric discharge, or plasma of any type, or ion/molecular exchange processes, adsorption/chemisorption processes, change of temperature or pressure, or change in the nature of the solvent or of its composition.

5. A process according to any of claims 1 to 4 wherein at least one of the monolayers is formed from an amphiphilic molecule having a polar binding group and a non-polar latent binding function or from an organic chromophore.

6.  A process according to any of claims 1 to 5 wherein at least one of the monolayers comprises a metal ion, a superconductor, or a metal species.

7.  A process according to claim 1, further, comprising:
    intercalating distinct chemical species between the layers of the initial superlattice.

8.  A process according to claim 8, wherein the composite superlattice is further modified by one or more chemical, photochemical, or electrochemical transformations or reactions.

9.  Composite organic-inorganic superlattices obtained by a process according to any of claims 1 to 8.

10. Use of a superlattice as claimed in claim 9 or produced by a process according to any of claims 1 to 8 in electronic, optical or optoelectronic applications.

EP 0 481 362 A2

# ARTIFICIAL SUPERLATTICE

Compositional
Modulation

↑

C C C C C C C C C
B B B B B B B B B
A A A A A A A A A
C C C C C C C C C
B B B B B B B B B
A A A A A A A A A

SUBSTRATE

FIG. 1

**CHEMICALLY - CONTROLLED SELF - ASSEMBLY**

*n* layers

*n* x Sequence

*3* layers

Repeat Sequence

*1* layer

A A A A A A A

1. Chemical "Trigger"
2. Layer Self-Assembly

*2* layers

B B B B B B B
A A A A A A A

Monolayer Self-Assembly
(Spontaneous Adsorption)

Fluid

A

Solid
Substrate

FIG. 2

FIG. 3

FIG. 4

EP 0 481 362 A2

FIG. 5

FIG. 6

BENZYL ORANGE

BO

BO Monolayer

BO Bilayer

Anchoring Silane Monolayer

1. KMnO$_4$/Benzene
2. HCl/H$_2$O

1. Ag$^+$
2. BO/H$_2$O, or
   BO/Bicyclohexyl

1. Ag$^+$
2. BO/H$_2$O or
   BO/Bicyclohexyl

SO$_3^-$ K$^+$

C$_{19}$ C$_{19}$

—Si—O—Si—

Quartz

COOH COOH

C$_{18}$ C$_{18}$

—Si—O—Si—

SO$_3^-$ SO$_3^-$

Ag$^+$ Ag$^+$

COO$^-$ COO$^-$

C$_{18}$ C$_{18}$

—Si—O—Si—

Ag$^+$ Ag$^+$

SO$_3^-$ SO$_3^-$

Ag$^+$ Ag$^+$

COO$^-$ COO$^-$

C$_{18}$ C$_{18}$

—Si—O—Si—

FIG. 7

EP 0 481 362 A2

FIG. 8

FIG. 9

4-DODECYLOXY-BENZOIC ACID

ABSORBANCE

.0054 .0045 .0036 .0027 .0018 .0009 .0000

CH$_3$

C$_{12}$

O

COOH

C$_{19}$

-O-Si-O-
|
O
|

Ag$^+$

Q

3050 3000 2950 2900 2850 2800 2750

WAVENUMBER

FIG. 10

EP 0 481 362 A2

4-DODECYLOXYBENZOIC ACID/Q

INCOMPLETE

FIG. 11

WAVELENGTH (nm)

ABSORBANCE

EP 0 481 362 A2

4-DDBA.AG_DIF SI(ATR)POLARIZED

FIG. 12(a)

EP 0 481 362 A2

FIG. 12(b)

FIG. 13

FIG. 14    WAVELENGTH (nm)

BO STRUCTURES ASSEMBLED FROM WATER

4-LAYERS

3-LAYERS

2-LAYERS

1-LAYER

ABSORBANCE

EP 0 481 362 A2

FIG. 15

FIG. 16

FIG. 17

FIG. 18

EP 0 481 362 A2

FIG. 19(1)

FIG. 19(2)

FIG. 19(3)